# EUROPEAN PATENT SPECIFICATION

(11) **EP 3 040 963 B1**
(45) Date of publication and mention of the grant of the patent: **16.01.2019**
(21) Application number: 15175885.1
(22) Date of filing: 08.07.2015
(51) Int. Cl.: G09G 3/20, G09G 3/32

(54) **ORGANIC LIGHT EMITTING DIODE DISPLAY AND METHOD FOR DRIVING THE SAME**
ANZEIGE MIT ORGANISCHEN LICHTEMITTIERENDEN DIODEN UND VERFAHREN ZUR ANSTEUERUNG DAVON
AFFICHAGE À DIODE ÉLECTROLUMINESCENTE ORGANIQUE ET SON PROCÉDÉ DE COMMANDE

(30) Priority: 30.12.2014 KR 20140194442
(43) Date of publication of application: 06.07.2016
(73) Proprietor: LG Display Co., Ltd., Yeongdeungpo-gu Seoul 150-721 (KR)
(72) Inventor: AHN, Younghwan, 413-190 Gyeonggi-do (KR); PARK, Dongwon, 410-360 Gyeonggi-do (KR); LEE, Joonhee, 140-173 Seoul (KR); KWON, Yongchul, 136-073 Seoul (KR)
(74) Representative: Morrall, Jonathan Ian McLachlan

(56) References cited:
- US-A1- 2010 188 393
- US-A1- 2012 320 005
- US-B2- 7 474 282

## Description

This application claims the benefit of Korea Patent Application No. 10-2014-0194442 filed on December 30, 2014.

### BACKGROUND

### Field

The present disclosure relates to an organic light emitting diode display driven through a digital driving method and a method for driving the same.

### Discussion of Related Art

Because an organic light emitting diode display (hereinafter, referred to as "OLED display") is a self-emission display device, the OLED display may be manufactured to have lower power consumption and thinner profile than a liquid crystal display requiring a backlight unit. Further, the OLED display has advantages of a wide viewing angle and a fast response time and thus has expanded its market while competing with the liquid crystal display.

The OLED display is driven through an analog voltage driving method or a digital driving method and may represent grayscale of an input image. The analog voltage driving method adjusts a data voltage applied to pixels based on data gray values of the input image and adjusts a luminance of the pixels based on a magnitude of the data voltage, thereby representing grayscale of the input image. The digital driving method adjusts an emission time of the pixels based on the data gray values of the input image, thereby representing grayscale of the input image.

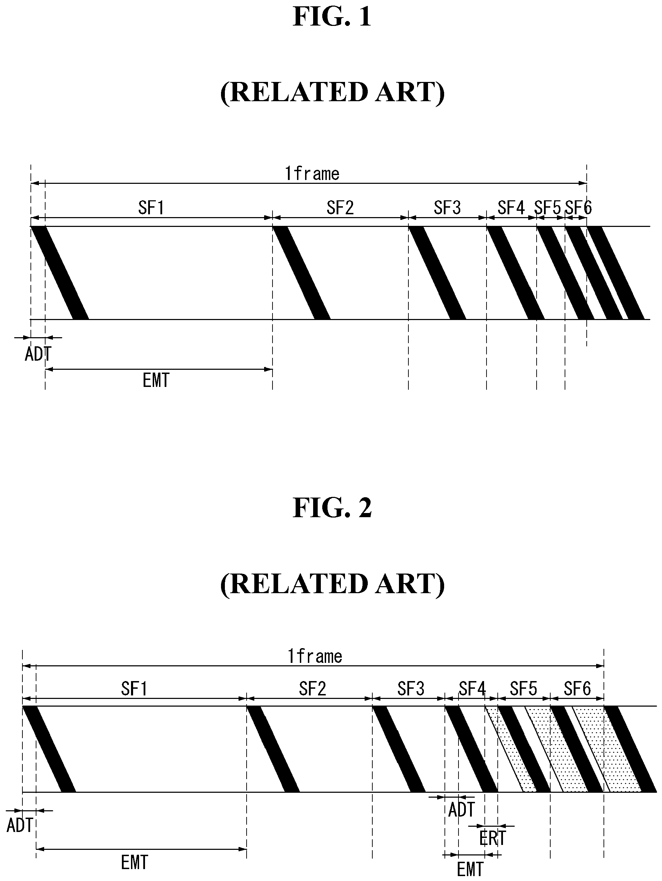

As shown in FIGS. 1 and 2, the digital driving method time-divides one frame into a plurality of subframes SF1 to SF6. Each subframe represents one bit of input image data. As shown in FIG. 1, each subframe may include a writing time ADT, during which data is written on pixels, and an emission time EMT, during which the pixels emit light. As shown in FIG. 2, each subframe may further include an erase time ERT, during which the pixels are turned off, in addition to the writing time ADT and the emission time EMT. The emission times of the subframes may have different lengths. However, all of the subframes are the same as one another in a scan direction for writing the data and an erase direction for turning off the pixels, and a writing speed for writing the data and an erase speed for turning off the pixels in each subframe are the same as each other. Therefore, the emission time of the same subframe is uniform irrespective of a position of the display panel.

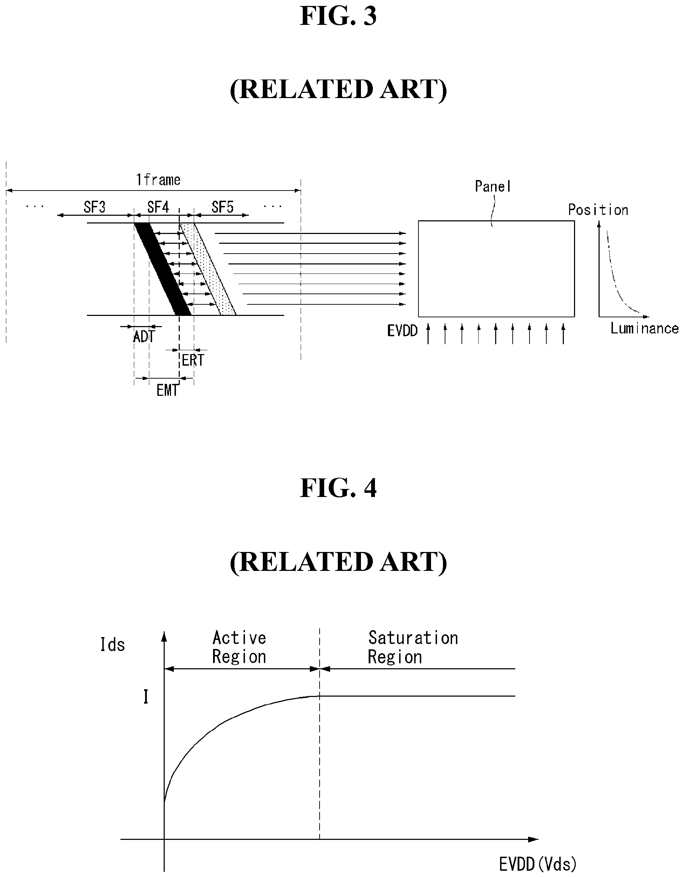

Because the emission time of the same subframe is uniform, it is a matter of course that there is no luminance deviation irrespective of the position of the display panel. However, in fact, as shown in FIG. 3, because IR drop resulting from a line resistance is generated in the display panel, a high potential power voltage EVDD varies depending on a spatial position of the display panel to thereby generate the luminance deviation. The luminance implemented in the display panel decreases as the display panel is far from an input terminal of the high potential power voltage EVDD.

In the analog voltage driving method, a driving thin film transistor (TFT) is driven in a saturation region. As shown in FIG. 4, the saturation region indicates a voltage region, in which a drain-source current Ids does not substantially change depending on a drain-source voltage Vds of the driving TFT, and is positioned on the right side of the Vds-Ids plane. In other words, in the saturation region, the drain-source current Ids does not change although the high potential power voltage EVDD (i.e., the drain-source voltage Vds of the driving TFT) changes.

On the other hand, in the digital driving method, the driving TFT is driven in an active region, so as to reduce power consumption. As shown in FIG. 4, the active region indicates a voltage region, in which the drain-source current Ids changes depending on the drain-source voltage Vds of the driving TFT, and is positioned on the left side of the Vds-Ids plane. In other words, in the active region, the drain-source current Ids sensitively changes depending on changes in the high potential power voltage EVDD (i.e., the drain-source voltage Vds of the driving TFT).

For this reason, the luminance deviation resulting from the IR drop is more of a problem in the digital driving method than the analog voltage driving method.

US 2012/0320005 A1 discloses a display apparatus in which selection signals are supplied sequentially to scanning lines in each subframe period including a frame period for performing a display scan to write display data into pixel circuits. Selection signals are also supplied sequentially to scanning lines in at least two subframe periods period for performing an erase scan to write erase data into pixel circuits. There is an overlapping period between periods from a start to an end of the erase scan in the at least two subframe periods. During the overlapping period, selection signals for performing the erase scan are supplied simultaneously to the scanning lines.

US 7,474,828 B2 discloses a display-unit-use display control method for control of display of pixels in a display unit including a large number of light emitting elements in a row direction and a column direction, the light emitting elements having brightness, which changes in accordance with a value of current supplied thereto. A current is supplied, the current supplying conductor from one or each end part thereof in a column direction, the current supplying conductor supplying the current to the light emitting elements. The pixels are displayed line by line in accordance with a selection timing, and the display of pixels is deleted line by line in accordance with a deletion timing.

### SUMMARY

Accordingly, the present disclosure provides an organic light emitting diode display driven through a digital driving method and a method for driving the same capable of minimizing a luminance deviation resulting from IR drop. Aspects of an invention are defined in the appended independent claims.

There is provided an organic light emitting diode display comprising a display panel including a plurality of pixels; a display panel driver configured to drive signal lines of the display panel; and a timing controller configured to divide one frame into a plurality of subframes, divide data of an input image at each bit, map the data of the input image to the plurality of subframes, control an operation of the display panel driver, and differently adjust a writing speed for writing data and an erase speed for turning off the pixels in at least one compensation frame of the plurality of subframes.

There is further provided a method for driving an organic light emitting diode display including a display panel including a plurality of pixels and a display panel driver driving signal lines of the display panel, the method comprising dividing one frame into a plurality of subframes, dividing data of an input image at each bit, and mapping the data of the input image to the plurality of subframes; and controlling an operation of the display panel driver and differently adjusting a writing speed for writing data and an erase speed for turning off the pixels in at least one compensation frame of the plurality of subframes.

### BRIEF DESCRIPTION OF THE DRAWINGS

The accompanying drawings, which are included to provide a further understanding of the present disclosure and are incorporated in and constitute a part of this specification. The drawings illustrate embodiments and together with the description serve to explain the principles of the present disclosure. In the drawings:
FIGS. 1 and 2 illustrate a related art digital driving method;
FIG. 3 shows that a luminance deviation resulting from IR drop is generated depending on a position of a display panel;
FIG. 4 shows a graph indicating operating characteristics of a driving thin film transistor (TFT);
FIGS. 5 and 6 show an organic light emitting diode display according to an exemplary embodiment of the invention;
FIG. 7 is a circuit diagram showing one pixel of the organic light emitting diode display shown in FIG. 6;
FIG. 8 shows an example where an erase speed and a writing speed in a specific compensation subframe are differently adjusted as a method for minimizing a luminance deviation resulting from IR drop;
FIG. 9 shows that a total application time of scan signals and a total application time of erase signals in the specific compensation subframe are differently controlled so as to implement the method shown in FIG. 8;
FIG. 10 shows another example where an erase speed and a writing speed in a specific compensation subframe are differently adjusted as a method for minimizing a luminance deviation resulting from IR drop;
FIG. 11 shows that a total application time of scan signals and a total application time of erase signals in the specific compensation subframe are differently controlled so as to implement the method shown in FIG. 10;
FIG. 12 shows an example where an erase speed and a writing speed in a specific compensation subframe are differently adjusted, and an erase speed of a portion of the specific compensation subframe is different from an erase speed of a remaining portion, as a method for minimizing a luminance deviation resulting from IR drop;
FIG. 13 shows that application times of erase signals in the specific compensation subframe are differently controlled depending on portions divided from the specific compensation subframe, so as to implement the method shown in FIG. 12;
FIG. 14 shows an example where a scanning direction and an erase direction in a specific compensation subframe are reversely adjusted as another method for minimizing a luminance deviation resulting from IR drop;
FIGS. 15A to 15C show examples where an erase speed in a compensation subframe is differently controlled depending on a degree of IR drop; and
FIGS. 16 and 17 show a comparison between a simulation result according to an embodiment and a related art.

### DETAILED DESCRIPTION OF THE ILLUSTRATED EMBODIMENTS

Reference will now be made in detail to embodiments, examples of which are illustrated in the accompanying drawings. Wherever possible, the like reference numbers will be used throughout the drawings to refer to the like parts. It will be paid attention that detailed description of known arts will be omitted if it is determined that the arts may mislead.

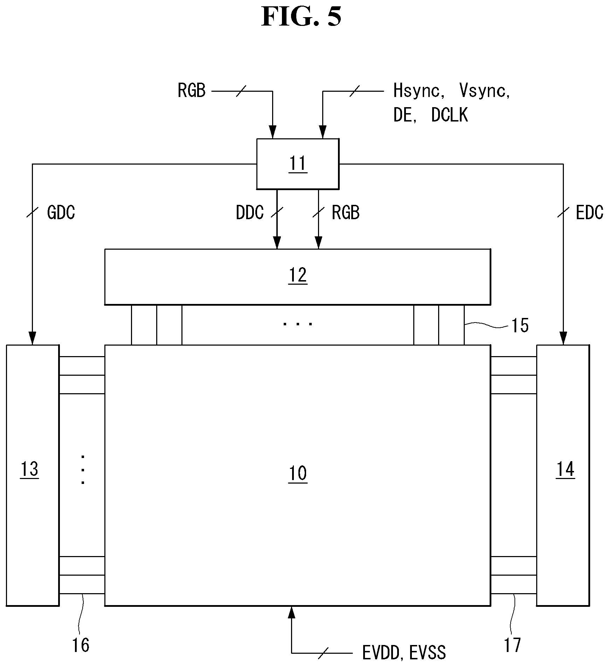

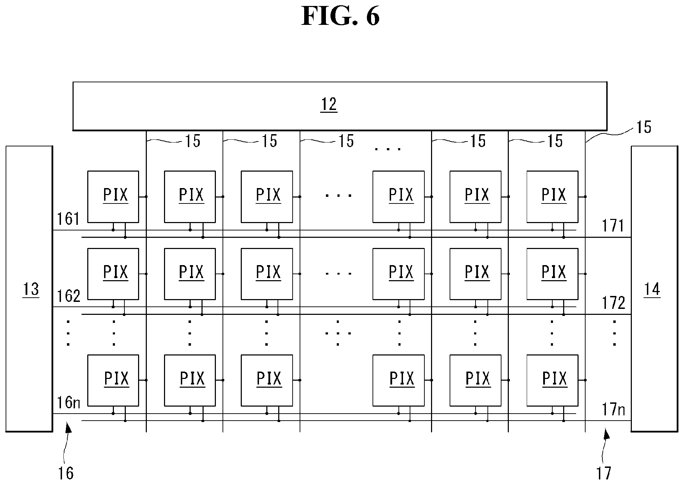

FIGS. 5 to 7 show an organic light emitting diode display (hereinafter, referred to as "OLED display") according to an embodiment.

Referring to FIGS. 5 to 7, the OLED display according to an embodiment includes a display panel 10, display panel drivers 12, 13, and 14 for writing pixel data of an input image on a pixel array of the display panel 10, and a timing controller 11 for controlling the display panel drivers 12, 13, and 14.

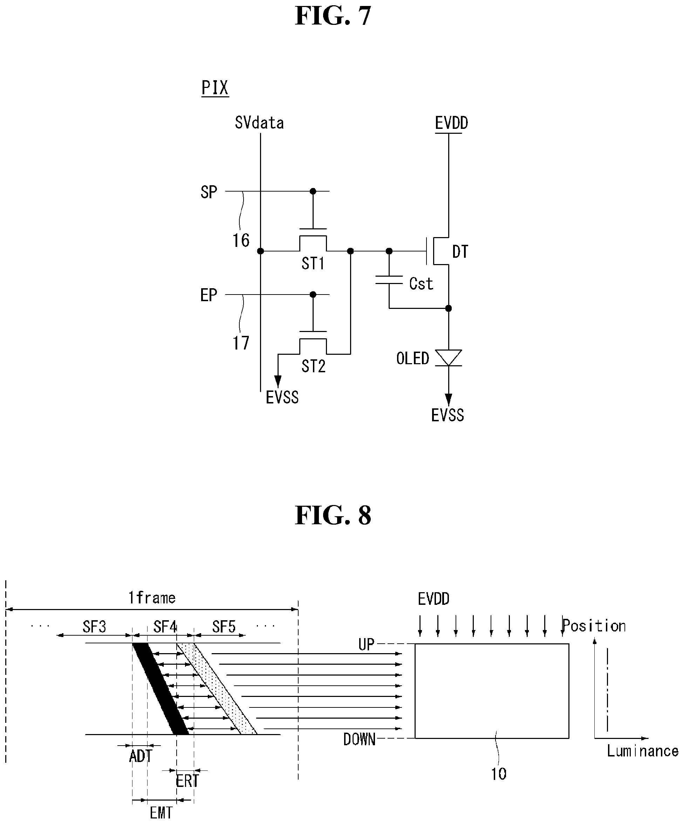

On the pixel array of the display panel 10, a plurality of data lines 15 and a plurality of first and second gate lines 16 and 17 cross each other. The pixel array of the display panel 10 includes pixels PIX, that are arranged in a matrix form and display the input image. Each pixel PIX may be one of a red (R) pixel, a green (G) pixel, a blue (B) pixel, and a white (W) pixel. As shown in FIG. 7, each pixel PIX may include a plurality of thin film transistors (TFTs), an organic light emitting diode (OLED), a capacitor, and the like.

The display panel drivers 12, 13, and 14 include a data driver 12, and first and second gate drivers 13 and 14.

The data driver 12 generates a data voltage SVdata based on data RGB of the input image received from the timing controller 11 and outputs the data voltage SVdata to the data lines 15. In a digital driving method, an amount of light emitted by the pixels PIX is uniform, and grayscale of the data RGB is represented through an amount of emission time, during which the pixels PIX emit light. Therefore, the data driver 12 selects one of a voltage (hereinafter, referred to as "on-voltage") satisfying an emission condition of the pixels PIX and a voltage (hereinafter, referred to as "off-voltage") not satisfying the emission condition of the pixels PIX depending on digital values of the data RGB mapped to the subframe and generates the data voltage SVdata.

The first gate driver 13 sequentially supplies a scan pulse (or a gate pulse) SP synchronized with the data voltage SVdata of the data driver 12 to the first gate lines 16 (i.e., 161 to 16n) under the control of the timing controller 11. The first gate driver 13 sequentially shifts the scan pulse SP and sequentially selects the pixels PIX, to which the data voltage SVdata is applied, on a per line basis.

The second gate driver 14 sequentially supplies an erase pulse EP to the second gate lines 17 (i.e., 171 to 17n) under the control of the timing controller 11. The pixels PIX stop emitting light in response to the erase pulse EP. The timing controller 11 controls application timing of the erase pulse EP and controls an emission time of each subframe.

The timing controller 11 receives the pixel data RGB of the input image and timing signals synchronized with the pixel data RGB from a host system (not shown). The timing controller 11 controls operation timing of the data driver 12 and operation timing of the gate drivers 13 and 14 based on the timing signals synchronized with the pixel data RGB of the input image. The timing signals include a vertical sync signal Vsync, a horizontal sync signal Hsync, a data enable signal DE, a dot clock DCLK, and the like. The timing controller 11 generates a source timing control signal DDC controlling the operation timing of the data driver 12, a first gate timing control signal GDC controlling the operation timing of the first gate driver 13, and a second gate timing control signal EDC controlling the operation timing of the second gate driver 14.

The timing controller 11 controls the display panel drivers 12, 13, and 14 through the digital driving method. The timing controller 11 divides one frame into a plurality of subframes. Lengths of the emission times of the subframes may be differently set depending on a data bit of the input image. For example, the most significant bit (MSB) represents a high gray level and thus may be mapped to the subframe having the long emission time, and the least significant bit (LSB) represents a low gray level and thus may be mapped to the subframe having the small emission time. The timing controller 11 maps the data RGB of the input image to the subframe at each bit and transmits the data RGB to the data driver 12.

As shown in FIGS. 8, 10, 12, and 14, each subframe may further include an erase time ERT, during which the pixels PIX are turned off, as well as a writing time ADT, during which the data is written on the pixels PIX, and an emission time EMT, during which the pixels PIX emit light. As described above, the emission times EMT of the subframes may have different lengths.

The timing controller 11 controls operations of the display panel drivers 12, 13, and 14 and differently adjusts a writing speed for the data write (indicating the application of the data voltage) and an erase speed for turning off the pixels PIX in at least one compensation subframe of the plurality of subframes. Hence, the timing controller 11 differently adjusts emission times of upper and lower display lines of the display panel 10 and can suppress a luminance deviation resulting from IR drop depending on a position of the display panel 10. This is described in detail later with reference to FIGS. 8 to 13.

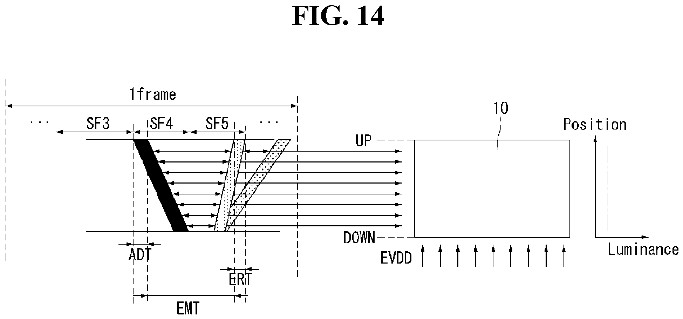

The timing controller 11 controls the operations of the display panel drivers 12, 13, and 14 and reversely adjusts a scan direction for the data write and an erase direction for turning off the pixels PIX in at least one compensation subframe of the plurality of subframes. Hence, the timing controller 11 differently adjusts emission times of the upper and lower display lines of the display panel 10 and can suppress the luminance deviation resulting from the IR drop depending on the position of the display panel 10. This is described in detail later with reference to FIGS. 14 to 15C.

The host system may be implemented as one of a television system, a set-top box, a navigation system, a DVD player, a Blu-ray player, a personal computer (PC), a home theater system, and a phone system.

As shown in FIG. 7, each pixel PIX includes an OLED, a driving TFT DT, a first switching TFT ST1, a second switching TFT ST2, a storage capacitor Cst, and the like.

The OLED has a stack structure of organic compound layers including a hole injection layer HIL, a hole transport layer HTL, an emission layer EML, an electron transport layer ETL, an electron injection layer EIL, etc. The OLED generates light when electrons and holes combine in the emission layer EML.

The driving TFT DT operates in the active region shown in FIG. 4 and makes the OLED emit light. The driving TFT DT is connected between a power line, to which a high potential power voltage EVDD is supplied, and the OLED and switches on or off a current flowing in the OLED depending on a voltage state of a gate node Ng. The driving TFT DT is turned on when the gate node Ng is in an on-voltage state, and applies a driving current to the OLED, thereby making the OLED emit light. The driving TFT DT is turned off when the gate node Ng is in an off-voltage state, and cuts off the driving current applied to the OLED, thereby turning off the OLED. Namely, the OLED does not emit light.

The first switching TFT ST1 is turned on in response to the scan pulse SP from the first gate line 16. The first switching TFT ST1 supplies the data voltage SVdata of the on-voltage or the off-voltage to the gate node Ng in response to the scan pulse SP.

The second switching TFT ST2 is turned on in response to the erase pulse EP from the second gate line 17. The second switching TFT ST2 makes a voltage of the gate node Ng in an off-voltage state in response to the erase pulse EP.

The storage capacitor Cst maintains the voltage of the gate node Ng of the driving TFT DT.

Each pixel PIX of the display panel 10 according to an embodiment is not limited to the structure shown in FIG. 7 and may have any pixel structure capable of performing the digital driving method.

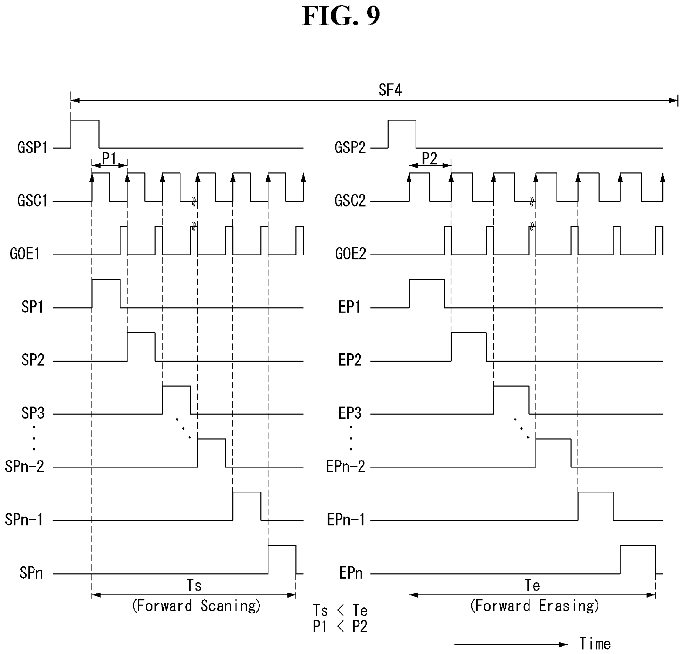

FIG. 8 shows an example where an erase speed and a writing speed in a specific compensation subframe are differently adjusted as a method for minimizing the luminance deviation resulting from the IR drop. FIG. 9 shows that a total application time of the scan signals and a total application time of the erase signals in the specific compensation subframe are differently controlled so as to implement the method shown in FIG. 8.

As shown in FIG. 8, in the OLED display according to an embodiment, the high potential power voltage EVDD for driving the pixels is applied to the display panel 10 from the upper side UP of the display panel 10, and the data write may be sequentially performed from the upper side UP to the lower side DOWN of the display panel 10 in a sequential line manner. In this instance, a luminance at the lower side DOWN of the display panel 10 may be less than a luminance at the upper side UP of the display panel 10 because of the IR drop.

To remove the luminance deviation depending on the position of the display panel 10, the timing controller 11 controls the operations of the display panel drivers 12, 13, and 14 such that an erase speed for turning off the pixels is slower than a writing speed for the data write in at least one compensation subframe (for example, SF4) of a plurality of subframes belonging to one frame. Hence, as it goes from the upper side UP to the lower side DOWN of the display panel 10, the emission time EMT may gradually increase.

The writing speed is determined in inverse proportion to a total application time of the scan signals for writing the data in the compensation subframe SF4, and the erase speed is determined in inverse proportion to a total application time of the erase signals for turning off the pixels in the compensation subframe SF4.

As shown in FIG. 9, the timing controller 11 may cause a total application time Te of erase signals EP1 to EPn to be longer than a total application time Ts of scan signals SP1 to SPn, so that the erase speed is slower than the writing speed in the compensation subframe SF4. For this, the timing controller 11 may cause a first gate shift clock GSC1, that forms the basis of the generation of the scan signals SP1 to SPn, to have a first pulse period P1 and cause a second gate shift clock GSC2, that forms the basis of the generation of the erase signals EP1 to EPn, to have a second pulse period P2 longer than the first pulse period P1.

The first gate driver 13 receives the first gate shift clock GSC1, a first gate start pulse GSP1, and a first gate output enable signal GOE1 from the timing controller 11 and generates the scan signals SP1 to SPn in synchronization with a rising edge of the first gate shift clock GSC1. The first gate driver 13 sequentially supplies the scan signals SP1 to SPn to the first gate lines 16 and scans the display lines of the display panel 10 in a forward direction during the total scanning time Ts.

The second gate driver 14 receives the second gate shift clock GSC2, a second gate start pulse GSP2, and a second gate output enable signal GOE2 from the timing controller 11 and generates the erase signals EP1 to EPn in synchronization with a rising edge of the second gate shift clock GSC2. The second gate driver 14 sequentially supplies the erase signals EP1 to EPn to the second gate lines 17 and erases the display lines of the display panel 10 in the forward direction during the total erase time Te longer than the total scanning time Ts.

As described above, this causes the erase speed to be slower than the writing speed when the high potential power voltage EVDD is applied to the display panel 10 from the upper side UP of the display panel 10 as shown in FIG. 8, and gradually increases the emission time EMT as it goes from the upper side UP to the lower side DOWN of the display panel 10, thereby removing the luminance deviation resulting from the IR drop depending on the position of the display panel 10.

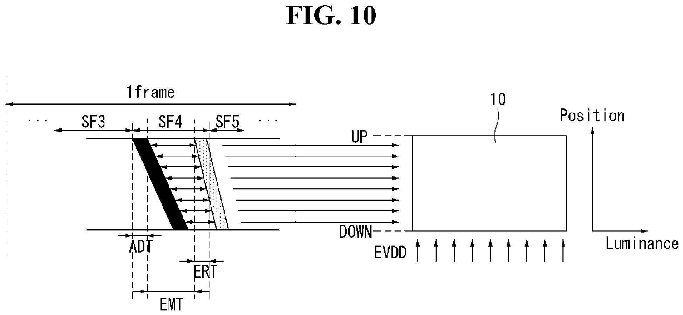

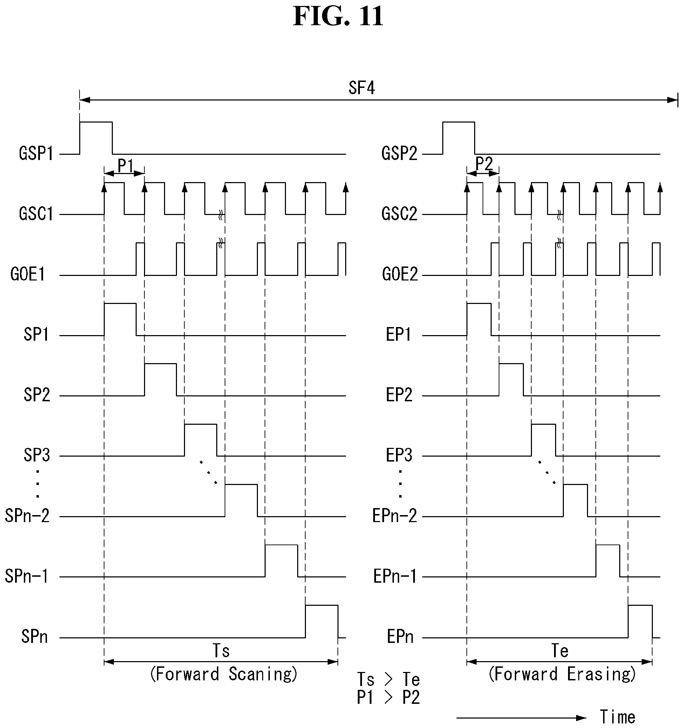

FIG. 10 shows another example where an erase speed and a writing speed in a specific compensation subframe are differently adjusted as a method for minimizing the luminance deviation resulting from the IR drop. FIG. 11 shows that a total application time of the scan signals and a total application time of the erase signals in the specific compensation subframe are differently controlled so as to implement the method shown in FIG. 10.

As shown in FIG. 10, in the OLED display according to a further embodiment, the high potential power voltage EVDD for driving the pixels is applied to the display panel 10 from the lower side DOWN of the display panel 10, and the data write may be sequentially performed from the upper side UP to the lower side DOWN of the display panel 10 in the sequential line manner. In this instance, a luminance at the upper side UP of the display panel 10 may be less than a luminance at the lower side DOWN of the display panel 10 because of the IR drop.

To remove the luminance deviation depending on the position of the display panel 10, the timing controller 11 controls the operations of the display panel drivers 12, 13, and 14 such that an erase speed for turning off the pixels is faster than a writing speed for the data write in at least one compensation subframe (for example, SF4) of a plurality of subframes belonging to one frame. Hence, as it goes from the lower side DOWN to the upper side UP of the display panel 10, the emission time EMT may gradually increase.

As shown in FIG. 11, the timing controller 11 may cause a total application time Te of the erase signals EP1 to EPn to be shorter than a total application time Ts of the scan signals SP1 to SPn, so that the erase speed is faster than the writing speed in the compensation subframe SF4. For this, the timing controller 11 may cause a first gate shift clock GSC1, that forms the basis of the generation of the scan signals SP1 to SPn, to have a first pulse period P1 and cause a second gate shift clock GSC2, that forms the basis of the generation of the erase signals EP1 to EPn, to have a second pulse period P2 shorter than the first pulse period P1.

The first gate driver 13 receives the first gate shift clock GSC1, a first gate start pulse GSP1, and a first gate output enable signal GOE1 from the timing controller 11 and generates the scan signals SP1 to SPn in synchronization with a rising edge of the first gate shift clock GSC1. The first gate driver 13 sequentially supplies the scan signals SP1 to SPn to the first gate lines 16 and scans the display lines of the display panel 10 in the forward direction during the total scanning time Ts.

The second gate driver 14 receives the second gate shift clock GSC2, a second gate start pulse GSP2, and a second gate output enable signal GOE2 from the timing controller 11 and generates the erase signals EP1 to EPn in synchronization with a rising edge of the second gate shift clock GSC2. The second gate driver 14 sequentially supplies the erase signals EP1 to EPn to the second gate lines 17 and erases the display lines of the display panel 10 in the forward direction during the total erase time Te shorter than the total scanning time Ts.

As described above, this causes the erase speed to be faster than the writing speed when the high potential power voltage EVDD is applied to the display panel 10 from the lower side DOWN of the display panel 10 as shown in FIG. 10, and gradually increases the emission time EMT as it goes from the lower side DOWN to the upper side UP of the display panel 10, thereby removing the luminance deviation resulting from the IR drop depending on the position of the display panel 10.

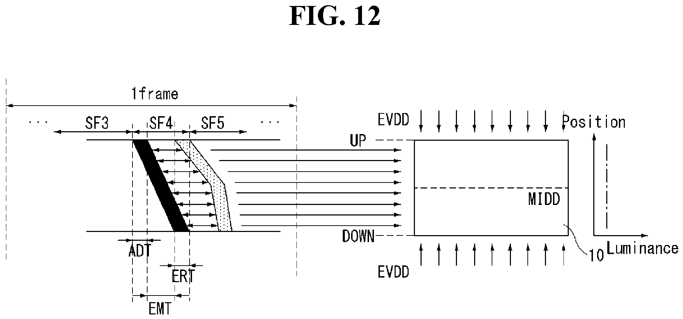

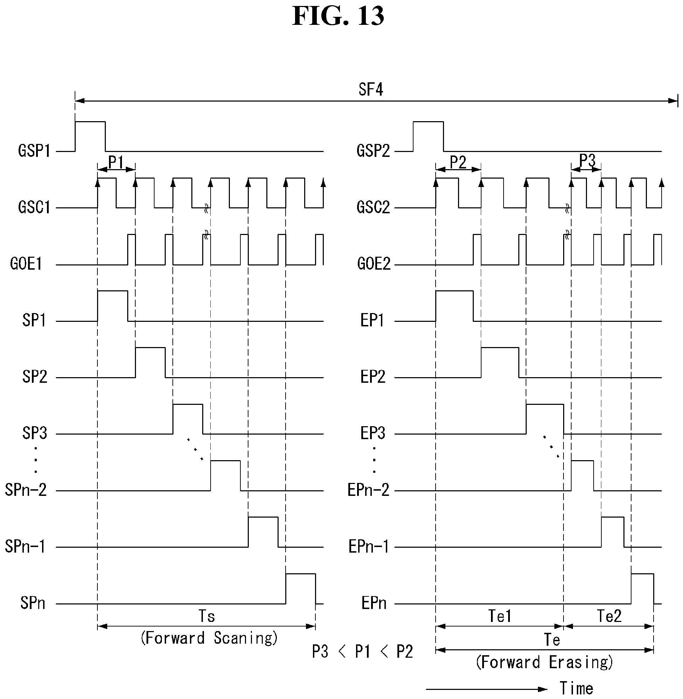

FIG. 12 shows an example where an erase speed and a writing speed in a specific compensation subframe are differently adjusted, and an erase speed in a portion of the specific compensation subframe is different from an erase speed in a remaining portion, as a method for minimizing the luminance deviation resulting from the IR drop. FIG. 13 shows that application times of erase signals in the specific compensation subframe are differently controlled depending on portions divided from the specific compensation subframe, so as to implement the method shown in FIG. 12.

As shown in FIG. 12, in the OLED display according to a yet further embodiment, the high potential power voltage EVDD for driving the pixels is simultaneously applied to the display panel 10 from both the upper side UP and the lower side DOWN of the display panel 10, and the data write may be sequentially performed from the upper side UP and the lower side DOWN of the display panel 10 in the sequential line manner. In this instance, a luminance at the middle part MIDD of the display panel 10 may be less than a luminance at the upper side UP and the lower side DOWN of the display panel 10 because of the IR drop.

To remove the luminance deviation depending on the position of the display panel 10, the timing controller 11 controls the operations of the display panel drivers 12, 13, and 14 such that an erase speed is slower than a writing speed in a portion of at least one compensation subframe (for example, SF4) of a plurality of subframes belonging to one frame, and then the erase speed is faster than the writing speed in a remaining portion of the compensation subframe SF4. Hence, as it goes from the upper side UP to the middle part MIDD of the display panel 10 and from the lower side DOWN to the middle part MIDD of the display panel 10, the emission time EMT may gradually increase.

The erase signals EP1 to EPn include first erase signals EP1 to EPk applied in the portion of the compensation subframe SF4 and second erase signals EP(k+1) to EPn applied in the remaining portion of the compensation subframe SF4. In this instance, as shown in FIG. 13, the timing controller 11 may cause a total application time Te of the erase signals EP1 to EPn to be same as a total application time Ts of the scan signals SP1 to SPn, divide the total application time Te of the erase signals EP1 to EPn into a first erase time Te1, during which the first erase signals EP1 to EPk are applied, and a second erase time Te2, during which the second erase signals EP(k+1) to EPn are applied, and cause the first erase time Te1 to be longer than the second erase time Te2, so as to differently adjust the erase speed depending on the portions divided from the compensation subframe SF4.

For this, the timing controller 11 may cause a first gate shift clock GSC1, that forms the basis of the generation of the scan signals SP1 to SPn, to have a first pulse period P1 and cause a second gate shift clock GSC2, that forms the basis of the generation of the erase signals EP1 to EPn, to have a second pulse period P2 longer than the first pulse period P1 during the first erase time Te1 and to have a third pulse period P3 shorter than the first pulse period P1 during the second erase time Te2.

The first gate driver 13 receives the first gate shift clock GSC1, a first gate start pulse GSP1, and a first gate output enable signal GOE1 from the timing controller 11 and generates the scan signals SP1 to SPn in synchronization with a rising edge of the first gate shift clock GSC1. The first gate driver 13 sequentially supplies the scan signals SP1 to SPn to the first gate lines 16 and scans the display lines of the display panel 10 in the forward direction during the total scanning time Ts.

The second gate driver 14 receives the second gate shift clock GSC2, a second gate start pulse GSP2, and a second gate output enable signal GOE2 from the timing controller 11 and generates the erase signals EP1 to EPn in synchronization with a rising edge of the second gate shift clock GSC2. The second gate driver 14 sequentially supplies the erase signals EP1 to EPn to the second gate lines 17 and erases the display lines of the display panel 10 in the forward direction at a first erase speed slower than the writing speed during the first erase time Te1 and at a second erase speed faster than the writing speed during the second erase time Te2.

As described above, thisdifferently adjusts the erase speed depending on the portions divided from the compensation subframe (i.e., causes the erase speed to be slower than the writing speed in the portion of the compensation subframe and to be faster than the writing speed in the remaining portion of the compensation subframe) when the high potential power voltage EVDD is simultaneously applied to the display panel 10 from both the upper side UP and the lower side DOWN of the display panel 10 as shown in FIG. 12. Hence, the embodiment of the invention gradually increases the emission time EMT as it goes from the upper side UP and the lower side DOWN to the middle part MIDD of the display panel 10, thereby removing the luminance deviation resulting from the IR drop depending on the position of the display panel 10.

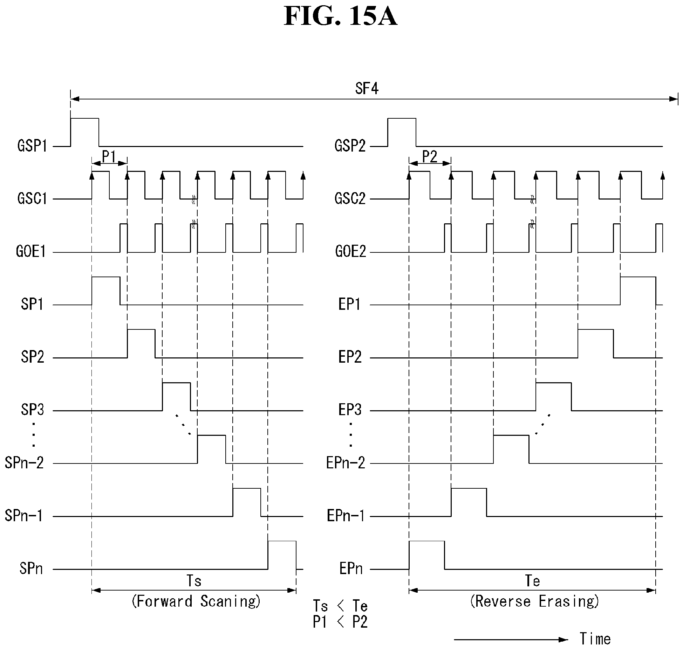

FIG. 14 shows an example where a scanning direction and an erase direction in a specific compensation subframe are reversely adjusted as another method for minimizing the luminance deviation resulting from the IR drop. FIGS. 15A to 15C show examples where an erase speed in a compensation subframe is differently controlled depending on a degree of the IR drop.

As shown in FIG. 14, in the OLED display according to a still further embodiment, the high potential power voltage EVDD for driving the pixels is applied to the display panel 10 from the lower side DOWN of the display panel 10, and the data write may be sequentially performed from the upper side UP to the lower side DOWN of the display panel 10 in the sequential line manner. In this instance, a luminance at the upper side UP of the display panel 10 may be less than a luminance at the lower side DOWN of the display panel 10 because of the IR drop.

To remove the luminance deviation depending on the position of the display panel 10, the timing controller 11 controls the operations of the display panel drivers 12, 13, and 14 such that a scanning direction for the data write and an erase direction for turning off the pixels may be reversed in at least one compensation subframe (for example, SF4) of a plurality of subframes belonging to one frame. For example, the timing controller 11 may define the scanning direction as a forward direction and define the erase direction as a reverse direction. Hence, the timing controller 11 can gradually increase the emission time EMT as it goes from the lower side DOWN to the upper side UP of the display panel 10.

The erase speed of the reverse direction may be differently determined depending on a degree of the luminance deviation resulting from the IR drop on the upper and lower sides of the display panel 10.

When the luminance deviation is large, the timing controller 11 may cause the erase speed of the reverse direction to be slower than the writing speed of the forward direction in the compensation subframe SF4. For this, as shown in FIG. 15A, the timing controller 11 may cause a total application time Te of the erase signals EP1 to EPn to be longer than a total application time Ts of the scan signals SP1 to SPn. The timing controller 11 may cause a first gate shift clock GSC1, that forms the basis of the generation of the scan signals SP1 to SPn, to have a first pulse period P1 and may cause a second gate shift clock GSC2, that forms the basis of the generation of the erase signals EP1 to EPn, to have a second pulse period P2 longer than the first pulse period P1. The first gate driver 13 sequentially supplies the scan signals SP1 to SPn to the first gate lines 16 in the forward direction and scans the display lines of the display panel 10 in the forward direction during the total scanning time Ts. The second gate driver 14 sequentially supplies the erase signals EP1 to EPn to the second gate lines 17 in the reverse direction and erases the display lines of the display panel 10 in the reverse direction during the total erase time Te longer than the total scanning time Ts.

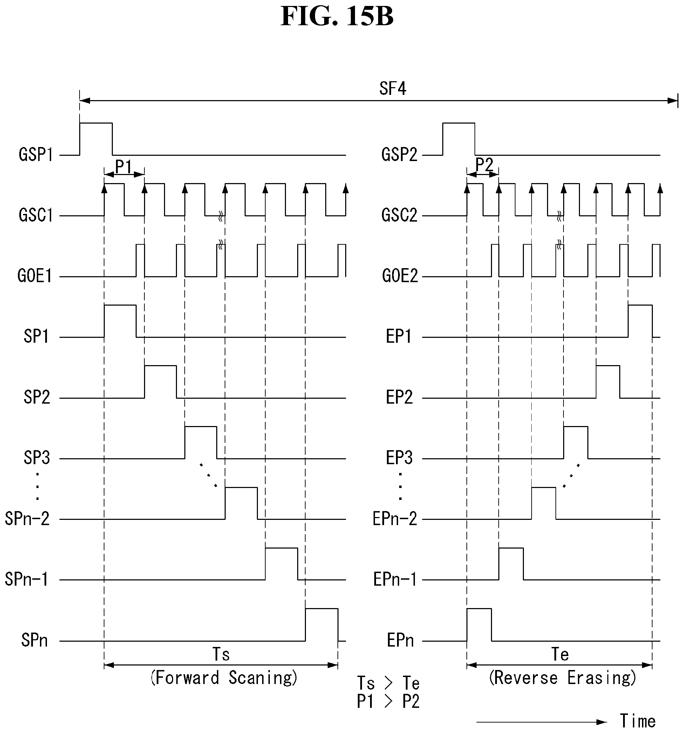

On the contrary, when the luminance deviation is small, the timing controller 11 may cause the erase speed of the reverse direction to be faster than the writing speed of the forward direction in the compensation subframe SF4. For this, as shown in FIG. 15B, the timing controller 11 may cause a total application time Te of the erase signals EP1 to EPn to be shorter than a total application time Ts of the scan signals SP1 to SPn. The timing controller 11 may cause the first gate shift clock GSC1, that forms the basis of the generation of the scan signals SP1 to SPn, to have the first pulse period P1 and may cause the second gate shift clock GSC2, that forms the basis of the generation of the erase signals EP1 to EPn, to have the second pulse period P2 shorter than the first pulse period P1. The first gate driver 13 sequentially supplies the scan signals SP1 to SPn to the first gate lines 16 in the forward direction and scans the display lines of the display panel 10 in the forward direction during the total scanning time Ts. The second gate driver 14 sequentially supplies the erase signals EP1 to EPn to the second gate lines 17 in the reverse direction and erases the display lines of the display panel 10 in the reverse direction during the total erase time Te shorter than the total scanning time Ts.

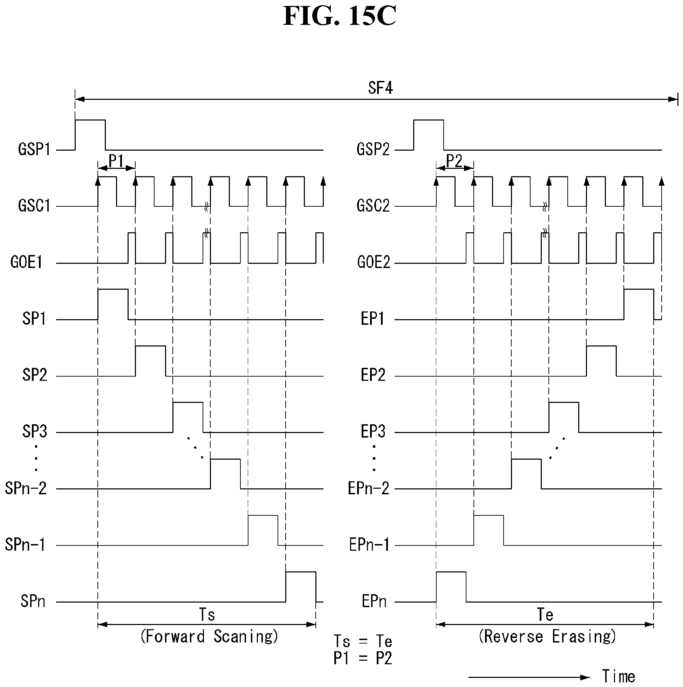

Alternatively, as shown in FIG. 15C, when the luminance deviation is small, the timing controller 11 may cause the erase speed of the reverse direction to be same as the writing speed of the forward direction in the compensation subframe SF4.

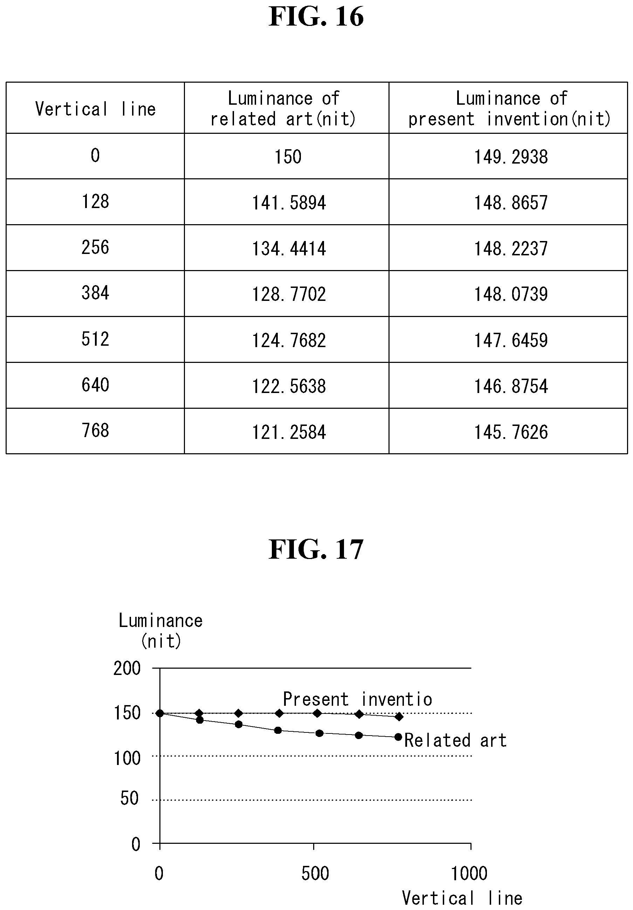

FIGS. 16 and 17 show a comparison between a simulation result according to an embodiment and a related art.

The present applicant adopted one configuration according to the embodiment shown in FIG. 8 and then measured luminances depending on the position of the display panel. Referring to FIG. 16, an increase in a value of a vertical line indicates that the position of the display panel is close to the lower side of the display panel.

As can be seen from the simulation result of FIGS. 16 and 17, the embodiment of the invention greatly reduced a deviation between the luminances of the upper and lower sides of the display panel, compared to the related art.

As described above, this selects at least one of the plurality of subframes belonging to one frame as the compensation subframe and causes the erase speed for turning off the pixels to be faster or slower than the writing speed for the data write in the compensation subframe, thereby differently controlling the emission times of the upper and lower display lines of the display panel. This can minimize the luminance deviation resulting from the IR drop.

Furthermore, this embodiment selects at least one of the plurality of subframes belonging to one frame as the compensation subframe and reversely controls the scanning direction for the data write and the erase direction for turning off the pixels in the compensation subframe, thereby differently controlling the emission times of the upper and lower display lines of the display panel. This can minimize the luminance deviation resulting from the IR drop.

Although embodiments have been described with reference to a number of illustrative embodiments thereof, it should be understood that numerous other modifications and embodiments can be devised by those skilled in the art that will fall within the scope of the appended claims. More particularly, various variations and modifications are possible in the component parts and/or arrangements of the subject combination arrangement within the scope of the appended claims. In addition to variations and modifications in the component parts and/or arrangements, alternative uses will also be apparent to those skilled in the art.

There is also provided an organic light emitting diode display including: a display panel including a plurality of pixels; a display panel driver configured to drive signal lines of the display panel; and a timing controller configured to divide one frame into a plurality of subframes, divide data of an input image at each bit, map the data of the input image to the plurality of subframes, control an operation of the display panel driver, and differently adjust a writing speed for writing data and an erase speed for turning off the pixels in at least one compensation frame of the plurality of subframes.

Optionally, when a high potential power voltage for driving the pixels is applied to the display panel from an upper side of the display panel, and the data write is sequentially performed from the upper side of the display panel to a lower side of the display panel opposite the upper side in a sequential line manner, the timing controller controls an operation of the display panel driver such that the erase speed is slower than the writing speed in the compensation subframe.

Optionally, the timing controller controls a total application time of erase signals for turning off the pixels to be longer than a total application time of scan signals for writing the data in the compensation subframe, and the timing controller controls a first gate shift clock, that forms the basis of the generation of the scan signals, to have a first pulse period and controls a second gate shift clock, that forms the basis of the generation of the erase signals, to have a second pulse period longer than the first pulse period.

Optionally, when a high potential power voltage for driving the pixels is applied to the display panel from a lower side of the display panel, and the data write is sequentially performed from an upper side opposite the lower side of the display panel to the lower side of the display panel in a sequential line manner, the timing controller controls an operation of the display panel driver such that the erase speed is faster than the writing speed in the compensation subframe.

Optionally, the timing controller controls a total application time of erase signals for turning off the pixels to be shorter than a total application time of scan signals for writing the data in the compensation subframe, and the timing controller controls a first gate shift clock, that forms the basis of the generation of the scan signals, to have a first pulse period and controls a second gate shift clock, that forms the basis of the generation of the erase signals, to have a second pulse period shorter than the first pulse period.

Optionally, when a high potential power voltage for driving the pixels is applied to the display panel from an upper side and a lower side of the display panel that are opposite to each other, and the data write is sequentially performed from the upper side to the lower side of the display panel in a sequential line manner, the timing controller controls an operation of the display panel driver such that the erase speed is slower than the writing speed in a portion of the compensation subframe, and then the erase speed is faster than the writing speed in a remaining portion of the compensation subframe.

Optionally erase signals for turning off the pixels include first erase signals applied in the portion of the compensation subframe and second erase signals applied in the remaining portion of the compensation subframe, and the timing controller controls a total application time of the erase signals to be same as a total application time of scan signals for writing the data in the compensation subframe, divides the total application time of the erase signals into a first erase time, during which the first erase signals are applied, and a second erase time, during which the second erase signals are applied, and controls the first erase time to be longer than the second erase time, and the timing controller controls a first gate shift clock, that forms the basis of the generation of the scan signals, to have a first pulse period and controls a second gate shift clock, that forms the basis of the generation of the erase signals, to have a second pulse period longer than the first pulse period during the first erase time and to have a third pulse period shorter than the first pulse period during the second erase time.

Optionally, the timing controller reversely adjusts a scanning direction for writing the data and an erase direction for turning off the pixels in the compensation subframe.

Optionally, an erase speed for turning off the pixels is determined based on a luminance deviation depending on a position of the display panel in the compensation subframe.

Optionally, each of the plurality of subframes includes a writing time during which the data is written on the pixels, an emission time during which the pixels emit light, and an erase time during which the pixels are turned off.

There is also provided a method for driving an organic light emitting diode display including a display panel including a plurality of pixels and a display panel driver driving signal lines of the display panel, the method including: dividing one frame into a plurality of subframes, dividing data of an input image at each bit, and mapping the data of the input image to the plurality of subframes; and controlling an operation of the display panel driver and differently adjusting a writing speed for writing data and an erase speed for turning off the pixels in at least one compensation frame of the plurality of subframes.

Optionally the method further includes reversely adjusting a scanning direction for writing the data and an erase direction for turning off the pixels in the compensation subframe.

Optionally, an erase speed for turning off the pixels is determined based on a luminance deviation depending on a position of the display panel in the compensation subframe.

Optionally, each of the plurality of subframes includes a writing time during which the data is written on the pixels, an emission time during which the pixels emit light, and an erase time during which the pixels are turned off.

## Claims

1. An organic light emitting diode display comprising:
a display panel (10) including a plurality of pixels;
a display panel driver (12, 13, 14) configured to drive signal lines of the display panel (10); and
a timing controller (11) configured to:
divide one frame into a plurality of subframes;
convert data of an input image into a bit pattern;
map the bit pattern to the plurality of subframes;
control an operation of the display panel driver (12, 13, 14);
wherein:
a high potential power voltage (EVDD) for driving the plurality of pixels is applied to the display panel (10) from a first side of the display panel (10), and writing data is sequentially performed from the first side of the display panel (10) to a second side of the display panel (10) opposite the first side sequentially in a line-by-line manner, and the timing controller (11) is further configured to:
adjust a writing speed for writing data and/or an erase speed for turning off pixels of the plurality of pixels in at least one compensation subframe (SF4) of the plurality of subframes such that the write speed and the erase speed are different from each other, wherein the writing speed is determined in inverse proportion to a total application time of the scan signals (SP1-SPn) for writing the data in the compensation subframe (SF4), and the erase speed is determined in inverse proportion to a total application time of the erase signals (EP1-EPn) for turning off the pixels in the compensation subframe (SF4);
control the total application time of the erase signals (EP1 to EPn) for turning off the plurality of pixels to be longer than the total application time of the scan signals (SP1 to SPn) for writing the data in the at least one compensation subframe (SF4), by controlling a first gate shift clock (GSC1), that forms the basis of the generation of the scan signals (SP1 to SPn), to have a first pulse period (PI); and by controlling a second gate shift clock (GSC2), that forms the basis of the generation of the erase signals (EP1 to EPn), to have a second pulse period (P2) longer than the first pulse period (P1),
so as to control an operation of the display panel driver (12, 13, 14) such that the erase speed is slower than the writing speed in the at least one compensation subframe (SF4).

2. An organic light emitting diode display comprising:
a display panel (10) including a plurality of pixels;
a display panel driver (12, 13, 14) configured to drive signal lines of the display panel (10); and
a timing controller (11) configured to:
divide one frame into a plurality of subframes;
convert data of an input image into a bit pattern;
map the bit pattern to the plurality of subframes;
control an operation of the display panel driver (12, 13, 14);
wherein:
a high potential power voltage (EVDD) for driving the plurality of pixels is applied to the display panel (10) from a second side of the display panel (10), and writing data is sequentially performed from a first side opposite the second side of the display panel (10) to the second side of the display panel (10) sequentially in a line-by-line manner, and the timing controller (11) is further configured to:
adjust a writing speed for writing data and/or an erase speed for turning off pixels of the plurality of pixels in at least one compensation subframe (SF4) of the plurality of subframes such that the write speed and the erase speed are different from each other, wherein the writing speed is determined in inverse proportion to a total application time of the scan signals (SP1-SPn) for writing the data in the compensation subframe (SF4), and the erase speed is determined in inverse proportion to a total application time of the erase signals (EP1-EPn) for turning off the pixels in the compensation subframe (SF4);
control the total application time of the erase signals (EP1 to EPn) for turning off the plurality of pixels to be shorter than the total application time of the scan signals (SP1 to SPn) for writing the data in the at least one compensation subframe (SF4) by controlling a first gate shift clock (GSC1), that forms the basis of the generation of the scan signals (SP1 to SPn), to have a first pulse period (PI); and by controlling a second gate shift clock (GCS2), that forms the basis of the generation of the erase signals (EP1 to EPn), to have a second pulse period (P2) shorter than the first pulse period (P1),
so as to control an operation of the display panel driver (12, 13, 14) such that the erase speed is faster than the writing speed in the at least one compensation subframe (SF4).

3. An organic light emitting diode display comprising:
a display panel (10) including a plurality of pixels;
a display panel driver (12, 13, 14) configured to drive signal lines of the display panel (10); and
a timing controller (11) configured to:
divide one frame into a plurality of subframes;
convert data of an input image into a bit pattern;
map the bit pattern to the plurality of subframes;
control an operation of the display panel driver (12, 13, 14);
wherein:
a high potential power voltage (EVDD) for driving the plurality of pixels is applied to the display panel (10) from a first side and a second side of the display panel (10) that are opposite to each other, writing data is sequentially performed from the first side to the second side of the display panel (10) sequentially in a line-by-line manner, and the timing controller (11) is further configured to: adjust a writing speed for writing data and/or an erase speed for turning off pixels of the plurality of pixels in at least one compensation subframe (SF4) of the plurality of subframes such that the write speed and the erase speed are different from each other, wherein the writing speed is determined in inverse proportion to a total application time of the scan signals for writing the data in the compensation subframe (SF4), and the erase speed is determined in inverse proportion to a total application time of the erase signals for turning off the pixels in a portion of the compensation subframe (SF4),
wherein the erase signals (EP1 to EPn) for turning off the plurality of pixels include first erase signals (EP1 to EPk) applied in a first portion of the at least one compensation subframe (SF4) and second erase signals (EPk+1 to EPn) applied in the remaining portion of the at least one compensation subframe (SF4),
wherein the timing controller (11) is further configured to:
control a total application time of the erase signals (EP1 to EPn) for turning off the pixels in the at least one compensation subframe (SF4) to be same as the total application time of the scan signals (SP1 to SPn) for writing the data in the at least one compensation subframe (SF4);
divide the total application time of the erase signals (EP1 to EPn) into a first erase time (Te1), during which the first erase signals (EP1 to EPk) are applied, and a second erase time (Te2), during which the second erase signals (EPk+1 to EPn) are applied;
control the first erase time (Te1) to be longer than the second erase time (Te2) by controlling a first gate shift clock (GSC1) to have a first pulse period (P1) and by controlling a second gate shift clock (GSC2) to have a second pulse period (P2) longer than the first pulse period (P1) during the first erase time (Te1) and to have a third pulse period (P3) shorter than the first pulse period (P1) during the second erase time (Te2),
wherein the first gate shift clock (GSC1) and second gate shift clock (GSC2) form the basis of the generation of the scan signals (SP1 to SPn) and the erase signals (EP1 to EPn), respectively,
so as to control an operation of the display panel driver (12, 13, 14) such that the erase speed is slower than the writing speed in the first portion of the at least one compensation subframe (SF4), and the erase speed is faster than the writing speed in the remaining portion of the at least one compensation subframe (SF4).

4. The organic light emitting diode display according to claim 2, wherein the timing controller (11) is configured to reverse a scanning direction for writing the data relative to an erase direction for turning off pixels of the plurality of pixels in the at least one compensation subframe (SF4).

5. The organic light emitting diode display according to any preceding claim, wherein the erase speed for turning off pixels of the plurality of pixels is determined based on a luminance deviation depending on a position on the display panel (10) in the at least one compensation subframe (SF4).

6. The organic light emitting diode display according to any one of claims 1 to 5, wherein each of the plurality of subframes includes a writing time (ADT) during which the data is written to pixels of the plurality of pixels, an emission time (EMT) during which the pixels emit light, and an erase time (ERT) during which the pixels are turned off.

7. A method for driving an organic light emitting diode display including a display panel (10) including a plurality of pixels and a display panel driver (12, 13, 14) driving signal lines of the display panel, the method comprising:
dividing one frame into a plurality of subframes;
converting data of an input image into a bit pattern;
mapping the bit pattern to the plurality of subframes;
applying a high potential power voltage (EVDD) for driving the plurality of pixels to the display panel (10) from a first side of the display panel;
writing data sequentially from the first side of the display panel (10) to a second side of the display panel opposite the first side sequentially in a line-by-line manner,
adjusting a writing speed for writing data and/or an erase speed for turning off pixels of the plurality of pixels in at least one compensation subframe (SF4) of the plurality of subframes, such that the write speed and the erase speed are different from each other, wherein the writing speed is determined in inverse proportion to a total application time of the scan signals for writing the data in the compensation subframe SF4, and the erase speed is determined in inverse proportion to a total application time of the erase signals for turning off the pixels in the compensation subframe (SF4);
controlling the total application time of the erase signals (EP1 to EPn) for turning off the plurality of pixels to be longer than the total application time of scan signals (SP1 to SPn) for writing the data in the at least one compensation subframe (SF4), by controlling a first gate shift clock (GSC1), that forms the basis of the generation of the scan signals (SP1 to SPn), to have a first pulse period (P1) and by controlling a second gate shift clock (GSC2), that forms the basis of the generation of the erase signals (EP1 to EPn), to have a second pulse period (P2) longer than the first pulse period (P1), so as to control the erase speed to be slower than the writing speed in the at least one compensation subframe (SF4).

8. A method for driving an organic light emitting diode display including a display panel (10) including a plurality of pixels and a display panel driver (12, 13, 14) driving signal lines of the display panel, the method comprising:
dividing one frame into a plurality of subframes;
converting data of an input image into a bit pattern;
mapping the bit pattern to the plurality of subframes;
applying a high potential power voltage (EVDD) for driving the plurality of pixels to the display panel (10) from a second side of the display panel (10);
writing data sequentially from a first side of the display panel (10) opposite the second side of the display panel (10) to the second side of the display panel (10) sequentially in a line-by-line manner;
adjusting a writing speed for writing data and/or an erase speed for turning off pixels of the plurality of pixels in at least one compensation subframe (SF4) of the plurality of subframes, such that the write speed and the erase speed are different from each other, wherein the writing speed is determined in inverse proportion to a total application time of the scan signals for writing the data in the compensation subframe (SF4), and the erase speed is determined in inverse proportion to a total application time of the erase signals for turning off the pixels in the compensation subframe (SF4);
controlling the total application time of the erase signals (EP1 to EPn) for turning off the plurality of pixels to be shorter than the total application time of the scan signals (SP1 to SPn) for writing the data in the at least one compensation subframe (SF4) by controlling a first gate shift clock (GSC1), that forms the basis of the generation of the scan signals (SP1 to SPn), to have a first pulse period (P1) and by controlling a second gate shift clock (GSC2), that forms the basis of the generation of the erase signals (EP1 to EPn), to have a second pulse period (P2) shorter than the first pulse period (P1), so as to control the erase speed to be faster than the writing speed in the at least one compensation subframe (SF4).

9. A method for driving an organic light emitting diode display including a display panel (10) including a plurality of pixels and a display panel driver (12, 13, 14) driving signal lines of the display panel, the method comprising:
dividing one frame into a plurality of subframes;
converting data of an input image into a bit pattern;
mapping the bit pattern to the plurality of subframes;
applying a high potential power voltage (EVDD) for driving the plurality of pixels to the display panel (10) from a first side and a second side of the display panel (10) that are opposite to each other;
writing data sequentially from the first side to the second side of the display panel (10) sequentially in a line-by-line manner;
adjusting a writing speed for writing data and/or an erase speed for turning off pixels of the plurality of pixels in at least one compensation subframe (SF4) of the plurality of subframes, such that the write speed and the erase speed are different from each other, wherein the writing speed is determined in inverse proportion to a total application time of the scan signals for writing the data in the compensation subframe (SF4), and the erase speed is determined in inverse proportion to a total application time of the erase signals for turning off the pixels in a portion of the compensation subframe (SF4);
wherein the erase signals (EP1 to EPn) for turning off the plurality of pixels include first erase signals (EP1 to EPk) applied in a first portion of the at least one compensation subframe (SF4) and second erase signals (EPk+1 to EPn) applied in the remaining portion of the at least one compensation subframe (SF4), the method further comprising:
controlling a total application time of the erase signals (EP1 to EPn) for turning off the pixels in the at least one compensation subframe (SF4) to be the same as the total application time of scan signals (SP1 to SPn) for writing the data in the at least one compensation subframe (SF4);
dividing the total application time of the erase signals (EP1 to EPn) into a first erase time (Te1), during which the first erase signals (EP1 to EPk) are applied, and a second erase time (Te2), during which the second erase signals (EPk+1 to EPn) are applied; and
controlling the first erase time (Te1) to be longer than the second erase time (Te2) by controlling a first gate shift clock (GSC1) to have a first pulse period (P1) and by controlling a second gate shift clock (GSC2) to have a second pulse period (P2) longer than the first pulse period (P1) during the first erase time (Te1), and to have a third pulse period (P3) shorter than the first pulse period (P1) during the second erase time (Te2), wherein the first gate shift clock (GSC1) and the second gate shift clock (GSC2) form the basis of the generation of the scan signals (SP1 to SPn) and the erase signals (EP1 to EPn), respectively, so as to control the erase speed to be slower than the writing speed in the first portion of the at least one compensation subframe (SF4), and the erase speed to be faster than the writing speed in the remaining portion of the at least one compensation subframe (SF4).

10. The method according to claim 8, further comprising reversing a scanning direction for writing the data relative to an erase direction for turning off pixels of the plurality of pixels in the at least one compensation subframe.

11. The method according to claim 10, wherein the erase speed for turning off pixels of the plurality of pixels is determined based on a luminance deviation depending on a position on the display panel (10) in the at least one compensation subframe (SF4).

12. The method according to any one of claims 7 to 11, wherein each of the plurality of subframes includes a writing time (ADT) during which the data is written to pixels of the plurality of pixels, an emission time (EMT) during which the pixels emit light, and an erase time (ERT) during which the pixels are turned off.

13. The method according to claim 9, wherein a first difference between the erase speed and the write speed in a first portion of the at least one compensation subframe (SF4) is different from a second difference between the erase speed and the write speed in a second portion of the at least one compensation subframe (SF4).

## Patentansprüche

1. Organische-Leuchtdiode-Anzeige, die Folgendes umfasst:
ein Anzeigefeld (10), das mehrere Pixel beinhaltet;
einen Anzeigefeldtreiber (12, 13, 14), der zum Treiben von Signalleitungen des Anzeigefelds (10) konfiguriert ist; und
eine Timing-Steuerung (11), die zu Folgendem konfiguriert ist:
Aufteilen eines Frames in mehrere Subframes;
Umwandeln von Daten eines Eingangsbildes in ein Bitmuster;
Zuordnen des Bitmusters zu den mehreren Subframes; Steuern eines Betriebs des Anzeigefeldtreibers (12, 13, 14) ;
wobei:
eine Hochpotentialleistungsspannung (EVDD) zum Treiben der mehreren Pixel an das Anzeigefeld (10) von einer ersten Seite des Anzeigefelds (10) angelegt wird und Schreiben von Daten sequenziell von der ersten Seite des Anzeigefelds (10) zu der zweiten Seite des Anzeigefelds (10), die der ersten Seite gegenüberliegt, sequenziell auf eine zeilenweise Art und Weise durchgeführt wird, und die Timing-Steuerung (11) ferner zu Folgendem konfiguriert ist:
Anpassen einer Schreibgeschwindigkeit zum Schreiben von Daten und/oder einer Löschgeschwindigkeit zum Ausschalten von Pixeln der mehreren Pixel in wenigstens einem Kompensation-Subframe (SF4) der mehreren Subframes, sodass die Schreibgeschwindigkeit und die Löschgeschwindigkeit voneinander verschieden sind, wobei die Schreibgeschwindigkeit in inverser Proportion zu einer gesamten Anwendungszeit der Scansignale (SP1-SPn) zum Schreiben der Daten in dem Kompensation-Subframe (SF4) bestimmt wird und die Löschgeschwindigkeit in inverser Proportion zu einer gesamten Anwendungszeit der Löschsignale (EP1-EPn) zum Ausschalten der Pixel in dem Kompensation-Subframe (SF4) bestimmt wird;
Steuern der gesamten Anwendungszeit der Löschsignale (EP1 bis EPn) zum Ausschalten der mehreren Pixel derart, dass sie länger als die gesamte Anwendungszeit der Scansignale (SP1 bis SPn) zum Schreiben der Daten in dem wenigstens einen Kompensation-Subframe (SF4) ist, durch Steuern eines ersten Gate-Verschiebung-Taktes (GSC1), der die Basis der Erzeugung der Scansignale (SP1 bis SPn) bildet, derart, dass er eine erste Pulsperiode (P1) aufweist; und durch Steuern eines zweiten Gate-Verschiebung-Taktes (GSC2), der die Basis der Erzeugung der Löschsignale (EP1 bis EPn) bildet, derart, dass er eine zweite Pulsperiode (P2) aufweist, die länger als die erste Pulsperiode (P1) ist, sodass ein Betrieb des Anzeigefeldtreibers (12, 13, 14) so gesteuert wird, dass die Löschgeschwindigkeit langsamer als die Schreibgeschwindigkeit in dem wenigstens einen Kompensation-Subframe (SF4) ist.

2. Organische-Leuchtdiode-Anzeige, die Folgendes umfasst:
ein Anzeigefeld (10), das mehrere Pixel beinhaltet;
einen Anzeigefeldtreiber (12, 13, 14), der zum Treiben von Signalleitungen des Anzeigefelds (10) konfiguriert ist; und
eine Timing-Steuerung (11), die zu Folgendem konfiguriert ist:
Aufteilen eines Frames in mehrere Subframes;
Umwandeln von Daten eines Eingangsbildes in ein Bitmuster;
Zuordnen des Bitmusters zu den mehreren Subframes; Steuern eines Betriebs des Anzeigefeldtreibers (12, 13, 14) ;
wobei:
eine Hochpotentialleistungsspannung (EVDD) zum Treiben der mehreren Pixel an das Anzeigefeld (10) von einer zweiten Seite des Anzeigefelds (10) angelegt wird und Schreiben von Daten sequenziell von einer ersten Seite, die der zweiten Seite gegenüberliegt, des Anzeigefelds (10) zu der zweiten Seite des Anzeigefelds (10) sequenziell auf eine zeilenweise Art und Weise durchgeführt wird, und die Timing-Steuerung (11) ferner zu Folgendem konfiguriert ist:
Anpassen einer Schreibgeschwindigkeit zum Schreiben von Daten und/oder einer Löschgeschwindigkeit zum Ausschalten von Pixeln der mehreren Pixel in wenigstens einem Kompensation-Subframe (SF4) der mehreren Subframes, sodass die Schreibgeschwindigkeit und die Löschgeschwindigkeit voneinander verschieden sind, wobei die Schreibgeschwindigkeit in inverser Proportion zu einer gesamten Anwendungszeit der Scansignale (SP1-SPn) zum Schreiben der Daten in dem Kompensation-Subframe (SF4) bestimmt wird und die Löschgeschwindigkeit in inverser Proportion zu einer gesamten Anwendungszeit der Löschsignale (EP1-EPn) zum Ausschalten der Pixel in dem Kompensation-Subframe (SF4) bestimmt wird;
Steuern der gesamten Anwendungszeit der Löschsignale (EP1 bis EPn) zum Ausschalten der mehreren Pixel derart, dass sie kürzer als die gesamte Anwendungszeit der Scansignale (SP1 bis SPn) zum Schreiben der Daten in dem wenigstens einen Kompensation-Subframe (SF4) ist, durch Steuern eines ersten Gate-Verschiebung-Taktes (GSC1), der die Basis der Erzeugung der Scansignale (SP1 bis SPn) bildet, derart, dass er eine erste Pulsperiode (P1) aufweist; und durch Steuern eines zweiten Gate-Verschiebung-Taktes (GCS2), der die Basis der Erzeugung der Löschsignale (EP1 bis EPn) bildet, derart, dass er eine zweite Pulsperiode (P2) aufweist, die kürzer als die erste Pulsperiode (P1) ist, sodass ein Betrieb des Anzeigefeldtreibers (12, 13, 14) so gesteuert wird, dass die Löschgeschwindigkeit schneller als die Schreibgeschwindigkeit in dem wenigstens einen Kompensation-Subframe (SF4) ist.

3. Organische-Leuchtdiode-Anzeige, die Folgendes umfasst:
ein Anzeigefeld (10), das mehrere Pixel beinhaltet;
einen Anzeigefeldtreiber (12, 13, 14), der zum Treiben von Signalleitungen des Anzeigefelds (10) konfiguriert ist; und
eine Timing-Steuerung (11), die zu Folgendem konfiguriert ist:
Aufteilen eines Frames in mehrere Subframes;
Umwandeln von Daten eines Eingangsbildes in ein Bitmuster;
Zuordnen des Bitmusters zu den mehreren Subframes; Steuern eines Betriebs des Anzeigefeldtreibers (12, 13, 14) ;
wobei:
eine Hochpotentialleistungsspannung (EVDD) zum Treiben der mehreren Pixel an das Anzeigefeld (10) von einer ersten Seite des Anzeigefelds (10) und einer zweiten Seite des Anzeigefelds (10), die einander gegenüber liegen, angelegt wird und Schreiben von Daten sequenziell von der ersten Seite zu der zweiten Seite des Anzeigefelds (10) sequenziell auf eine zeilenweise Art und Weise durchgeführt wird, und die Timing-Steuerung (11) ferner zu Folgendem konfiguriert ist:
Anpassen einer Schreibgeschwindigkeit zum Schreiben von Daten und/oder einer Löschgeschwindigkeit zum Ausschalten von Pixeln der mehreren Pixel in wenigstens einem Kompensation-Subframe (SF4) der mehreren Subframes, sodass die Schreibgeschwindigkeit und die Löschgeschwindigkeit voneinander verschieden sind, wobei die Schreibgeschwindigkeit in inverser Proportion zu einer gesamten Anwendungszeit der Scansignale zum Schreiben der Daten in dem Kompensation-Subframe (SF4) bestimmt wird und die Löschgeschwindigkeit in inverser Proportion zu einer gesamten Anwendungszeit der Löschsignale zum Ausschalten der Pixel in einem Teil des Kompensation-Subframes (SF4) bestimmt wird,
wobei die Löschsignale (EP1 bis EPn) zum Ausschalten der mehreren Pixel erste Löschsignale (EP1 bis EPk), die in einem ersten Teil des wenigstens einen Kompensation-Subframes (SF4) angewandt werden, und zweite Löschsignale (EPk+1 bis EPn), die in dem verbleibenden Teil des wenigstens einen Kompensation-Subframes (SF4) angewandt werden, beinhalten,
wobei die Timing-Steuerung (11) ferner zu Folgendem konfiguriert ist:
Steuern einer gesamten Anwendungszeit der Löschsignale (EP1 bis EPn) zum Ausschalten der Pixel im dem wenigstens einen Kompensation-Subframe (SF4) derart, dass sie gleich der gesamten Anwendungszeit der Scansignale (SP1 bis SPn) zum Schreiben der Daten in dem wenigstens einen Kompensation-Subframe (SF4) ist;
Aufteilen der gesamten Anwendungszeit der Löschsignale (EP1 bis EPn) in eine erste Löschzeit (Te1), während der die ersten Löschsignale (EP1 bis EPk) angewandt werden, und eine zweite Löschzeit (Te2), während der die zweiten Löschsignale (EPk+1 bis EPn) angewandt werden;
Steuern der ersten Löschzeit (Te1) derart, dass sie länger als die zweite Löschzeit (Te2) ist, durch Steuern eines ersten Gate-Verschiebung-Taktes (GSC1) derart, dass er eine erste Pulsperiode (P1) aufweist, und durch Steuern eines zweiten Gate-Verschiebung-Taktes (GSC2) derart, dass er eine zweite Pulsperiode (P2), die länger als die erste Pulsperiode (P1) ist, während der ersten Löschzeit (Te1) aufweist und eine dritte Pulsperiode (P3), die kürzer als die erste Pulsperiode (P1) ist, während der zweiten Löschzeit (Te2) aufweist,
wobei der erste Gate-Verschiebung-Takt (GSC1) und der zweite Gate-Verschiebung-Takt (GSC2) die Basis der Erzeugung der Scansignale (SP1 bis SPn) bzw. der Löschsignale (EP1 bis EPn) bilden, sodass ein Betrieb des Anzeigefeldtreibers (12, 13, 14) so gesteuert wird, dass die Löschgeschwindigkeit langsamer als die Schreibgeschwindigkeit in dem ersten Teil des wenigstens einen Kompensation-Subframes (SF4) ist und die Löschgeschwindigkeit schneller als die Schreibgeschwindigkeit in dem verbleibenden Teil des wenigstens einen Kompensation-Subframes (SF4) ist.

4. Organische-Leuchtdiode-Anzeige nach Anspruch 2, wobei die Timing-Steuerung (11) zum Umkehren einer Scanrichtung zum Schreiben der Daten relativ zu einer Löschrichtung zum Ausschalten von Pixeln der mehreren Pixel in dem wenigstens einen Kompensation-Subframe (SF4) konfiguriert ist.

5. Organische-Leuchtdiode-Anzeige nach einem vorhergehenden Anspruch, wobei die Löschgeschwindigkeit zum Ausschalten von Pixeln der mehreren Pixel basierend auf einer Leuchtdichtenabweichung in Abhängigkeit von einer Position auf dem Anzeigefeld (10) in dem wenigstens einen Kompensation-Subframe (SF4) bestimmt wird.

6. Organische-Leuchtdiode-Anzeige nach einem der Ansprüche 1 bis 5, wobei jeder der mehreren Subframes eine Schreibzeit (ADT), während der die Daten in die Pixel der mehreren Pixel geschrieben werden, eine Emissionszeit (EMT), während der die Pixel Licht emittieren, und eine Löschzeit (ERT), während der die Pixel ausgeschaltet sind, beinhaltet.

7. Verfahren zum Ansteuern einer Organische-Leuchtdiode-Anzeige, die ein Anzeigefeld (10), das mehrere Pixel beinhaltet, und einen Anzeigefeldtreiber (12, 13, 14), der Signalleitungen des Anzeigefelds treibt, beinhaltet, wobei das Verfahren Folgendes umfasst:
Aufteilen eines Frames in mehrere Subframes;
Umwandeln von Daten eines Eingangsbildes in ein Bitmuster;
Zuordnen des Bitmusters zu den mehreren Subframes;
Anlegen einer Hochpotentialleistungsspannung (EVDD) zum Treiben der mehreren Pixel an das Anzeigefeld (10) von einer ersten Seite des Anzeigefelds;
Schreiben von Daten sequenziell von der ersten Seite des Anzeigefelds (10) zu einer zweiten Seite des Anzeigefelds, die der ersten Seite gegenüberliegt, sequenziell auf eine zeilenweise Art und Weise;
Anpassen einer Schreibgeschwindigkeit zum Schreiben von Daten und/oder einer Löschgeschwindigkeit zum Ausschalten von Pixeln der mehreren Pixel in wenigstens einem Kompensation-Subframe (SF4) der mehreren Subframes, sodass die Schreibgeschwindigkeit und die Löschgeschwindigkeit voneinander verschieden sind, wobei die Schreibgeschwindigkeit in inverser Proportion zu einer gesamten Anwendungszeit der Scansignale zum Schreiben der Daten in den Kompensation-Subframe SF4 bestimmt wird und die Löschgeschwindigkeit in inverser Proportion zu einer gesamten Anwendungszeit der Löschsignale zum Ausschalten der Pixel in dem Kompensation-Subframe (SF4) bestimmt wird;
Steuern der gesamten Anwendungszeit der Löschsignale (EP1 bis EPn) zum Ausschalten der mehreren Pixel derart, dass sie länger als die gesamte Anwendungszeit der Scansignale (SP1 bis SPn) zum Schreiben der Daten in dem wenigstens einen Kompensation-Subframe (SF4) ist, durch Steuern eines ersten Gate-Verschiebung-Taktes (GSC1), der die Basis der Erzeugung der Scansignale (SP1 bis SPn) bildet, derart, dass er eine erste Pulsperiode (P1) aufweist, und durch Steuern eines zweiten Gate-Verschiebung-Taktes (GSC2), der die Basis der Erzeugung der Löschsignale (EP1 bis EPn) bildet, derart, dass er eine zweite Pulsperiode (P2) aufweist, die länger als die erste Pulsperiode (P1) ist, sodass die Löschgeschwindigkeit so gesteuert wird, dass sie langsamer als die Schreibgeschwindigkeit in dem wenigstens einen Kompensation-Subframe (SF4) ist.

8. Verfahren zum Ansteuern einer Organische-Leuchtdiode-Anzeige, die ein Anzeigefeld (10), das mehrere Pixel beinhaltet, und einen Anzeigefeldtreiber (12, 13, 14), der Signalleitungen des Anzeigefelds ansteuert, beinhaltet, wobei das Verfahren Folgendes umfasst:
Aufteilen eines Frames in mehrere Subframes;
Umwandeln von Daten eines Eingangsbildes in ein Bitmuster;
Zuordnen des Bitmusters zu den mehreren Subframes;
Anlegen einer Hochpotentialleistungsspannung (EVDD) zum Treiben der mehreren Pixel an das Anzeigefeld (10) von einer zweiten Seite des Anzeigefelds (10);
Schreiben von Daten sequenziell von einer ersten Seite des Anzeigefelds (10), die der zweiten Seite des Anzeigefelds (10) gegenüberliegt, zu der zweiten Seite des Anzeigefelds (10) sequenziell auf eine zeilenweise Art und Weise;
Anpassen einer Schreibgeschwindigkeit zum Schreiben von Daten und/oder einer Löschgeschwindigkeit zum Ausschalten von Pixeln der mehreren Pixel in wenigstens einem Kompensation-Subframe (SF4) der mehreren Subframes, sodass die Schreibgeschwindigkeit und die Löschgeschwindigkeit voneinander verschieden sind, wobei die Schreibgeschwindigkeit in inverser Proportion zu einer gesamten Anwendungszeit der Scansignale zum Schreiben der Daten in dem Kompensation-Subframe (SF4) bestimmt wird und die Löschgeschwindigkeit in inverser Proportion zu einer gesamten Anwendungszeit der Löschsignale zum Ausschalten der Pixel in dem Kompensation-Subframe (SF4) bestimmt wird;
Steuern der gesamten Anwendungszeit der Löschsignale (EP1 bis EPn) zum Ausschalten der mehreren Pixel derart, dass sie kürzer als die gesamte Anwendungszeit der Scansignale (SP1 bis SPn) zum Schreiben der Daten in dem wenigstens einen Kompensation-Subframe (SF4) ist, durch Steuern eines ersten Gate-Verschiebung-Taktes (GSC1), der die Basis der Erzeugung der Scansignale (SP1 bis SPn) bildet, derart, dass er eine erste Pulsperiode (P1) aufweist, und durch Steuern eines zweiten Gate-Verschiebung-Taktes (GSC2), der die Basis der Erzeugung der Löschsignale (EP1 bis EPn) bildet, derart, dass er eine zweite Pulsperiode (P2) aufweist, die kürzer als die erste Pulsperiode (P1) ist, sodass die Löschgeschwindigkeit so gesteuert wird, dass sie schneller als die Schreibgeschwindigkeit in dem wenigstens einen Kompensation-Subframe (SF4) ist.

9. Verfahren zum Ansteuern einer Organische-Leuchtdiode-Anzeige, die ein Anzeigefeld (10), das mehrere Pixel beinhaltet, und einen Anzeigefeldtreiber (12, 13, 14), der Signalleitungen des Anzeigefelds (10) steuert, beinhaltet, wobei das Verfahren Folgendes umfasst:
Aufteilen eines Frames in mehrere Subframes;
Umwandeln von Daten eines Eingangsbildes in ein Bitmuster;
Zuordnen des Bitmusters zu den mehreren Subframes;
Anlegen einer Hochpotentialleistungsspannung (EVDD) zum Treiben der mehreren Pixel an das Anzeigefeld (10) von einer ersten Seite und einer zweiten Seite des Anzeigefelds (10), die einander gegenüber liegen;
Schreiben von Daten sequenziell von der ersten Seite zu der zweiten Seite des Anzeigefelds (10) sequenziell auf eine zeilenweise Art und Weise;
Anpassen einer Schreibgeschwindigkeit zum Schreiben von Daten und/oder einer Löschgeschwindigkeit zum Ausschalten von Pixeln der mehreren Pixel in wenigstens einem Kompensation-Subframe (SF4) der mehreren Subframes, sodass die Schreibgeschwindigkeit und die Löschgeschwindigkeit voneinander verschieden sind, wobei die Schreibgeschwindigkeit in inverser Proportion zu einer gesamten Anwendungszeit der Scansignale zum Schreiben der Daten in dem Kompensation-Subframe (SF4) bestimmt wird und die Löschgeschwindigkeit in inverser Proportion zu einer gesamten Anwendungszeit der Löschsignale zum Ausschalten der Pixel in einem Teil des Kompensation-Subframes (SF4) bestimmt wird,
wobei die Löschsignale (EP1 bis EPn) zum Ausschalten der mehreren Pixel erste Löschsignale (EP1 bis EPk), die in einem ersten Teil des wenigstens einen Kompensation-Subframes (SF4) angewandt werden, und zweite Löschsignale (EPk+1 bis EPn), die in dem verbleibenden Teil des wenigstens einen Kompensation-Subframes (SF4) angewandt werden, beinhalten, wobei das Verfahren ferner Folgendes umfasst:
Steuern einer gesamten Anwendungszeit der Löschsignale (EP1 bis EPn) zum Ausschalten der Pixel in dem mindestens einen Kompensation-Subframe (SF4) derart, dass sie gleich der gesamten Anwendungszeit der Scansignale (SP1 bis SPn) zum Schreiben der Daten in dem wenigstens einen Kompensation-Subframe (SF4) ist;
Aufteilen der gesamten Anwendungszeit der Löschsignale (EP1 bis EPn) in eine erste Löschzeit (Te1), während der die ersten Löschsignale (EP1 bis EPk) angewandt werden, und eine zweite Löschzeit (Te2), während der die zweiten Löschsignale (EPk+1 bis EPn) angewandt werden; und
Steuern der ersten Löschzeit (Te1) derart, dass sie länger als die zweite Löschzeit (Te2) ist, durch Steuern eines ersten Gate-Verschiebung-Taktes (GSC1) derart, dass er eine erste Pulsperiode (P1) aufweist, und durch Steuern eines zweiten Gate-Verschiebung-Taktes (GSC2) derart, dass er eine zweite Pulsperiode (P2), die länger als die erste Pulsperiode (P1) ist, während der ersten Löschzeit (Te1) aufweist und eine dritte Pulsperiode (P3), die kürzer als die erste Pulsperiode (P1) ist, während der zweiten Löschzeit (Te2) aufweist, wobei der erste Gate-Verschiebung-Takt (GSC1) und der zweite Gate-Verschiebung-Takt (GSC2) die Basis der Erzeugung der Scansignale (SP1 bis SPn) bzw. der Löschsignale (EP1 bis EPn) bilden, sodass die Löschgeschwindigkeit so gesteuert wird, dass sie langsamer als die Schreibgeschwindigkeit in dem ersten Teil des wenigstens einen Kompensation-Subframes (SF4) ist und die Löschgeschwindigkeit schneller als die Schreibgeschwindigkeit in dem verbleibenden Teil des wenigstens einen Kompensation-Subframes (SF4) ist.

10. Verfahren nach Anspruch 8, das ferner Umkehren einer Scanrichtung zum Schreiben der Daten relativ zu einer Löschrichtung zum Ausschalten von Pixeln der mehreren Pixel in dem wenigstens einen Kompensation-Subframe umfasst.

11. Verfahren nach Anspruch 10, wobei die Löschgeschwindigkeit zum Ausschalten von Pixeln der mehreren Pixel basierend auf einer Leuchtdichtenabweichung in Abhängigkeit von einer Position auf dem Anzeigefeld (10) in dem wenigstens einen Kompensation-Subframe (SF4) bestimmt wird.

12. Verfahren nach einem der Ansprüche 7 bis 11, wobei jeder der mehreren Subframes eine Schreibzeit (ADT), während der die Daten in die Pixel der mehreren Pixel geschrieben werden, eine Emissionszeit (EMT), während der die Pixel Licht emittieren, und eine Löschzeit (ERT), während der die Pixel ausgeschaltet sind, beinhaltet.

13. Verfahren nach Anspruch 9, wobei eine erste Differenz zwischen der Löschgeschwindigkeit und der Schreibgeschwindigkeit in einem ersten Teil des wenigstens einen Kompensation-Subframes (SF4) verschieden von einer zweiten Differenz zwischen der Löschgeschwindigkeit und der Schreibgeschwindigkeit in einem zweiten Teil des wenigstens einen Kompensation-Subframes (SF4) ist.

## Revendications

1. Ecran à diodes électroluminescentes organiques comprenant :
un écran d'affichage (10) incluant une pluralité de pixels ;
un pilote d'écran d'affichage (12, 13, 14) configuré pour piloter des lignes de signal de l'écran d'affichage (10) ; et
un contrôleur de minutage (11) configuré pour :
diviser une trame en une pluralité de sous-trames ;
convertir des données d'une image d'entrée en un profil binaire ;
mettre en correspondance le profil binaire avec la pluralité de sous-trames ;
contrôler une opération du pilote d'écran d'affichage (12, 13, 14) ;
dans lequel :
une tension d'alimentation à haut potentiel (EVDD) pour piloter la pluralité de pixels est appliquée à l'écran d'affichage (10) depuis un premier côté de l'écran d'affichage (10), et l'écriture de données est séquentiellement réalisée depuis le premier côté de l'écran d'affichage (10) vers un second côté de l'écran d'affichage (10) opposé au premier côté, séquentiellement, ligne par ligne,
et le contrôleur de minutage (11) est en outre configuré pour :
ajuster une vitesse d'écriture pour écrire des données et/ou une vitesse d'effacement pour éteindre des pixels de la pluralité de pixels dans au moins une sous-trame de compensation (SF4) de la pluralité de sous-trames de sorte que la vitesse d'écriture et la vitesse d'effacement soient différentes l'une de l'autre, dans lequel la vitesse d'écriture est déterminée en proportion inverse à un temps total d'application des signaux de balayage (SP1-SPn) pour écrire les données dans la sous-trame de compensation (SF4), et la vitesse d'effacement est déterminée en proportion inverse à un temps total d'application des signaux d'effacement (EP1-EPn) pour éteindre les pixels dans la sous-trame de compensation (SF4) ;
contrôler le temps total d'application des signaux d'effacement (EP1 à EPn) pour éteindre la pluralité de pixels pour qu'il soit plus long que le temps total d'application des signaux de balayage (SP1 à SPn) pour écrire les données dans l'au moins une sous-trame de compensation (SF4), en contrôlant une première horloge de décalage de porte (GSC1), qui forme la base de la génération des signaux de balayage (SP1 à SPn), pour qu'elle ait une première période d'impulsion (P1) ; et en contrôlant une seconde horloge de décalage de porte (GSC2), qui forme la base de la génération des signaux d'effacement (EP1 à EPn), pour qu'elle ait une deuxième période d'impulsion (P2) plus longue que la première période d'impulsion (P1), de façon à contrôler une opération du pilote d'écran d'affichage (12, 13, 14) de sorte que la vitesse d'effacement soit plus lente que la vitesse d'écriture dans l'au moins une sous-trame de compensation (SF4).

2. Ecran à diodes électroluminescentes organiques comprenant :
un écran d'affichage (10) incluant une pluralité de pixels ;
un pilote d'écran d'affichage (12, 13, 14) configuré pour piloter des lignes de signal de l'écran d'affichage (10) ; et
un contrôleur de minutage (11) configuré pour :
diviser une trame en une pluralité de sous-trames ;
convertir des données d'une image d'entrée en un profil binaire ;
mettre en correspondance le profil binaire avec la pluralité de sous-trames ;
contrôler une opération du pilote d'écran d'affichage (12, 13, 14) ;
dans lequel :
une tension d'alimentation à haut potentiel (EVDD) pour piloter la pluralité de pixels est appliquée à l'écran d'affichage (10) depuis un second côté de l'écran d'affichage (10), et l'écriture des données est séquentiellement réalisée depuis un premier côté opposé au second côté de l'écran d'affichage (10) vers le second côté de l'écran d'affichage (10), séquentiellement, ligne par ligne, et le contrôleur de minutage (11) est en outre configuré pour :
ajuster une vitesse d'écriture pour écrire des données et/ou une vitesse d'effacement pour éteindre des pixels de la pluralité de pixels dans au moins une sous-trame de compensation (SF4) de la pluralité de sous-trames de sorte que la vitesse d'écriture et la vitesse d'effacement soient différentes l'une de l'autre, dans lequel la vitesse d'écriture est déterminée en proportion inverse à un temps total d'application des signaux de balayage (SP1-SPn) pour écrire les données dans la sous-trame de compensation (SF4), et la vitesse d'effacement est déterminée en proportion inverse à un temps total d'application des signaux d'effacement (EP1-EPn) pour éteindre les pixels dans la sous-trame de compensation (SF4) ;
contrôler le temps total d'application des signaux d'effacement (EP1 à EPn) pour éteindre la pluralité de pixels pour qu'il soit plus long que le temps total d'application des signaux de balayage (SP1 à SPn) pour écrire les données dans l'au moins une sous-trame de compensation (SF4), en contrôlant une première horloge de décalage de porte (GSC1), qui forme la base de la génération des signaux de balayage (SP1 à SPn), pour qu'elle ait une première période d'impulsion (P1) ; et en contrôlant une seconde horloge de décalage de porte (GCS2), qui forme la base de la génération des signaux d'effacement (EP1 à EPn), pour qu'elle ait une deuxième période d'impulsion (P2) plus courte que la première période d'impulsion (P1), de façon à contrôler une opération du pilote d'écran d'affichage (12, 13, 14) de sorte que la vitesse d'effacement soit plus rapide que la vitesse d'écriture dans l'au moins une sous-trame de compensation (SF4).

3. Ecran à diodes électroluminescentes organiques comprenant :
un écran d'affichage (10) incluant une pluralité de pixels ;
un pilote d'écran d'affichage (12, 13, 14) configuré pour piloter des lignes de signal de l'écran d'affichage (10) ; et
un contrôleur de minutage (11) configuré pour :
diviser une trame en une pluralité de sous-trames ;
convertir des données d'une image d'entrée en un profil binaire ;
mettre en correspondance le profil binaire avec la pluralité de sous-trames ;
contrôler une opération du pilote d'écran d'affichage (12, 13, 14) ;
dans lequel :
une tension d'alimentation à haut potentiel (EVDD) pour piloter la pluralité de pixels est appliquée à l'écran d'affichage (10) depuis un premier côté et un second côté de l'écran d'affichage (10) qui sont opposés l'un à l'autre, l'écriture des données est séquentiellement réalisée depuis le premier côté vers le second côté de l'écran d'affichage (10) séquentiellement, ligne par ligne, et le contrôleur de minutage (11) est en outre configuré pour :
ajuster une vitesse d'écriture pour écrire des données et/ou une vitesse d'effacement pour éteindre des pixels de la pluralité de pixels dans au moins une sous-trame de compensation (SF4) de la pluralité de sous-trames de sorte que la vitesse d'écriture et la vitesse d'effacement soient différentes l'une de l'autre, dans lequel la vitesse d'écriture est déterminée en proportion inverse à un temps total d'application des signaux de balayage pour écrire les données dans la sous-trame de compensation (SF4), et la vitesse d'effacement est déterminée en proportion inverse à un temps total d'application des signaux d'effacement pour éteindre les pixels dans une portion de la sous-trame de compensation (SF4), dans lequel les signaux d'effacement (EP1 à EPn) pour éteindre la pluralité de pixels incluent des premiers signaux d'effacement (EP1 à EPk) appliqués dans une première portion de l'au moins une sous-trame de compensation (SF4) et des seconds signaux d'effacement (EPk+1 à EPn) appliqués dans la portion restante de l'au moins une sous-trame de compensation (SF4),
dans lequel le contrôleur de minutage (11) est en outre configuré pour :
contrôler un temps total d'application des signaux d'effacement (EP1 à EPn) (SF4) pour éteindre les pixels dans l'au moins une sous-trame de compensation (SF4) pour qu'il soit le même que le temps total d'application des signaux de balayage (SP1 à SPn) pour écrire les données dans l'au moins une sous-trame de compensation (SF4) ;
diviser le temps total d'application des signaux d'effacement (EP1 à EPn) en un premier temps d'effacement (Te1), pendant lequel les premiers signaux d'effacement (EP1 à EPk) sont appliqués, et en un second temps d'effacement (Te2), pendant lequel les seconds signaux d'effacement (EPk+1 à EPn) sont appliqués ;
contrôler le premier temps d'effacement (Te1) pour qu'il soit plus long que le second temps d'effacement (Te2), en contrôlant une première horloge de décalage de porte (GSC1) pour qu'elle ait une première période d'impulsion (P1) et en contrôlant une seconde horloge de décalage de porte (GSC2) pour qu'elle ait une deuxième période d'impulsion (P2) plus longue que la première période d'impulsion (P1) pendant le premier temps d'effacement (Te1) et pour qu'elle ait une troisième période d'impulsion (P3) plus courte que la première période d'impulsion (P1) pendant le second temps d'effacement (Te2),
dans lequel la première horloge de décalage de porte (GSC1) et la seconde horloge de décalage de porte (GSC2) forment la base de la génération des signaux de balayage (SP1 à SPn) et des signaux d'effacement (EP1 à EPn), respectivement, de façon à contrôler une opération du pilote d'écran d'affichage (12, 13, 14) de sorte que la vitesse d'effacement soit plus lente que la vitesse d'écriture dans la première portion de l'au moins une sous-trame de compensation (SF4), et que la vitesse d'effacement soit plus rapide que la vitesse d'écriture dans la portion restante de l'au moins une sous-trame de compensation (SF4).

4. Ecran à diodes électroluminescentes organiques selon la revendication 2, dans lequel le contrôleur de minutage (11) est configuré pour inverser une direction de balayage pour écrire les données par rapport à une direction d'effacement pour éteindre des pixels de la pluralité de pixels dans l'au moins une sous-trame de compensation (SF4).

5. Ecran à diodes électroluminescentes organiques selon l'une quelconque des revendications précédentes, dans lequel la vitesse d'effacement pour éteindre des pixels de la pluralité de pixels est déterminée d'après un écart de luminance en fonction d'une position de l'écran d'affichage (10) dans l'au moins une sous-trame de compensation (SF4).

6. Ecran à diodes électroluminescentes organiques selon l'une quelconque des revendications 1 à 5, dans lequel chacune de la pluralité de sous-trames inclut un temps d'écriture (ADT) pendant lequel les données sont écrites en pixels de la pluralité de pixels, un temps d'émission (EMT) pendant lequel les pixels émettent une lumière, et un temps d'effacement (ERT) pendant lequel les pixels sont éteints.

7. Procédé de pilotage d'un écran à diodes électroluminescentes organiques incluant un écran d'affichage (10) incluant une pluralité de pixels et un pilote d'écran d'affichage (12, 13, 14) pilotant des lignes de signal de l'écran d'affichage, le procédé comprenant :
la division d'une trame en une pluralité de sous-trames ;
la conversion de données d'une image d'entrée en un profil binaire ;
la mise en correspondance du profil binaire avec la pluralité de sous-trames ;
l'application d'une tension d'alimentation à haut potentiel (EVDD) pour piloter la pluralité de pixels à l'écran d'affichage (10) depuis un premier côté de l'écran d'affichage ;
l'écriture séquentielle de données depuis le premier côté de l'écran d'affichage (10) vers un second côté de l'écran d'affichage opposé au premier côté, séquentiellement, ligne par ligne ;
l'ajustement d'une vitesse d'écriture pour écrire des données et/ou d'une vitesse d'effacement pour éteindre des pixels de la pluralité de pixels dans au moins une sous-trame de compensation (SF4) de la pluralité de sous-trames, de sorte que la vitesse d'écriture et la vitesse d'effacement soient différentes l'une de l'autre, dans lequel la vitesse d'écriture est déterminée en proportion inverse à un temps total d'application des signaux de balayage pour écrire les données dans la sous-trame de compensation SF4, et la vitesse d'effacement est déterminée en proportion inverse à un temps total d'application des signaux d'effacement pour éteindre les pixels dans la sous-trame de compensation SF4 ;
le contrôle du temps total d'application des signaux d'effacement (EP1 à EPn) pour éteindre la pluralité de pixels pour qu'il soit plus long que le temps total d'application des signaux de balayage (SP1 à SPn) pour écrire les données dans l'au moins une sous-trame de compensation (SF4), en contrôlant une première horloge de décalage de porte (GSC1), qui forme la base de la génération des signaux de balayage (SP1 à SPn), pour qu'elle ait une première période d'impulsion (P1) et en contrôlant une seconde horloge de décalage de porte (GSC2), qui forme la base de la génération des signaux d'effacement (EP1 à EPn), pour qu'elle ait une deuxième période d'impulsion (P2) plus longue que la première période d'impulsion (P1), de façon à contrôler la vitesse d'effacement pour qu'elle soit plus lente que la vitesse d'écriture dans l'au moins une sous-trame de compensation (SF4).

8. Procédé de pilotage d'un écran à diodes électroluminescentes organiques incluant un écran d'affichage (10) incluant une pluralité de pixels et un pilote d'écran d'affichage (12, 13, 14) pilotant des lignes de signal de l'écran d'affichage, le procédé comprenant :
la division d'une trame en une pluralité de sous-trames ;
la conversion de données d'une image d'entrée en un profil binaire ;
la mise en correspondance du profil binaire avec la pluralité de sous-trames ;
l'application d'une tension d'alimentation à haut potentiel (EVDD) pour piloter la pluralité de pixels à l'écran d'affichage (10) depuis un second côté de l'écran d'affichage (10) ;
l'écriture séquentielle de données depuis un premier côté de l'écran d'affichage (10) opposé au second côté de l'écran d'affichage (10) vers le second côté de l'écran d'affichage (10) séquentiellement, ligne par ligne ;
l'ajustement d'une vitesse d'écriture pour écrire des données et/ou d'une vitesse d'effacement pour éteindre des pixels de la pluralité de pixels dans au moins une sous-trame de compensation (SF4) de la pluralité de sous-trames, de sorte que la vitesse d'écriture et la vitesse d'effacement soient différentes l'une de l'autre, dans lequel la vitesse d'écriture est déterminée en proportion inverse à un temps total d'application des signaux de balayage pour écrire les données dans la sous-trame de compensation (SF4), et la vitesse d'effacement est déterminée en proportion inverse à un temps total d'application des signaux d'effacement pour éteindre les pixels dans la sous-trame de compensation SF4 ;
le contrôle du temps total d'application des signaux d'effacement (EP1 à EPn) pour éteindre la pluralité de pixels pour qu'il soit plus court que le temps total d'application des signaux de balayage (SP1 à SPn) pour écrire les données dans l'au moins une sous-trame de compensation (SF4), en contrôlant une première horloge de décalage de porte (GSC1), qui forme la base de la génération des signaux de balayage (SP1 à SPn), pour qu'elle ait une première période d'impulsion (P1) et en contrôlant une seconde horloge de décalage de porte (GSC2), qui forme la base de la génération des signaux d'effacement (EP1 à EPn), pour qu'elle ait une deuxième période d'impulsion (P2) plus courte que la première période d'impulsion (P1), de façon à contrôler la vitesse d'effacement pour qu'elle soit plus rapide que la vitesse d'écriture dans l'au moins une sous-trame de compensation (SF4).

9. Procédé de pilotage d'un écran à diodes électroluminescentes organiques incluant un écran d'affichage (10) incluant une pluralité de pixels et un pilote d'écran d'affichage (12, 13, 14) pilotant des lignes de signal de l'écran d'affichage, le procédé comprenant :
la division d'une trame en une pluralité de sous-trames ;
la conversion de données d'une image d'entrée en un profil binaire ;
la mise en correspondance du profil binaire avec la pluralité de sous-trames ;
l'application d'une tension d'alimentation à haut potentiel (EVDD) pour piloter la pluralité de pixels à l'écran d'affichage (10) depuis un premier côté et un second côté de l'écran d'affichage (10) qui sont opposés l'un à l'autre ;
l'écriture séquentielle de données depuis le premier côté vers le second côté de l'écran d'affichage (10), séquentiellement, ligne par ligne ;
l'ajustement d'une vitesse d'écriture pour écrire des données et/ou d'une vitesse d'effacement pour éteindre des pixels de la pluralité de pixels dans au moins une sous-trame de compensation (SF4) de la pluralité de sous-trames, de sorte que la vitesse d'écriture et la vitesse d'effacement soient différentes l'une de l'autre, dans lequel la vitesse d'écriture est déterminée en proportion inverse à un temps total d'application des signaux de balayage pour écrire les données dans la sous-trame de compensation (SF4), et la vitesse d'effacement est déterminée en proportion inverse à un temps total d'application des signaux d'effacement pour éteindre les pixels dans la sous-trame de compensation (SF4) ;
dans lequel les signaux d'effacement (EP1 à EPn) pour éteindre la pluralité de pixels incluent des premiers signaux d'effacement (EP1 à EPk) appliqués dans une première portion de l'au moins une sous-trame de compensation (SF4) et des seconds signaux d'effacement (EPk+1 à EPn) appliqués dans la portion restante de l'au moins une sous-trame de compensation (SF4), le procédé comprenant en outre :
le contrôle d'un temps total d'application des signaux d'effacement (EP1 à EPn) pour éteindre les pixels dans l'au moins une sous-trame de compensation (SF4) pour qu'il soit le même que le temps total d'application des signaux de balayage (SP1 à SPn) pour écrire les données dans l'au moins une sous-trame de compensation (SF4) ;
la division du temps total d'application des signaux d'effacement (EP1 à EPn) en un premier temps d'effacement (Te1), pendant lequel les premiers signaux d'effacement (EP1 à EPk) sont appliqués, et en un second temps d'effacement (Te2), pendant lequel les seconds signaux d'effacement (EPk+1 à EPn) sont appliqués ; et le contrôle du premier temps d'effacement (Te1) pour qu'il soit plus long que le second temps d'effacement (Te2), en contrôlant une première horloge de décalage de porte (GSC1) pour qu'elle ait une première période d'impulsion (P1) et en contrôlant une seconde horloge de décalage de porte (GSC2) pour qu'elle ait une deuxième période d'impulsion (P2) plus longue que la première période d'impulsion (P1) pendant le premier temps d'effacement (Te1) et pour qu'elle ait une troisième période d'impulsion (P3) plus courte que la première période d'impulsion (P1) pendant le second temps d'effacement (Te2), dans lequel la première horloge de décalage de porte (GSC1) et la seconde horloge de décalage de porte (GSC2) forment la base de la génération des signaux de balayage (SP1 à SPn) et des signaux d'effacement (EP1 à EPn), respectivement, de façon à contrôler la vitesse d'effacement pour qu'elle soit plus lente que la vitesse d'écriture dans la première portion de l'au moins une sous-trame de compensation (SF4), et la vitesse d'effacement pour qu'elle soit plus rapide que la vitesse d'écriture dans la portion restante de l'au moins une sous-trame de compensation (SF4).

10. Procédé selon la revendication 8, comprenant en outre l'inversion d'une direction de balayage pour écrire les données par rapport à une direction d'effacement pour éteindre des pixels de la pluralité de pixels dans l'au moins une sous-trame de compensation.

11. Procédé selon la revendication 10, dans lequel la vitesse d'effacement pour éteindre les pixels de la pluralité de pixels est déterminée d'après un écart de luminance en fonction d'une position sur l'écran d'affichage (10) dans l'au moins une sous-trame de compensation (SF4).

12. Procédé selon l'une quelconque des revendications 7 à 11, dans lequel chacune de la pluralité de sous-trames inclut un temps d'écriture (ADT) pendant lequel les données sont écrites en pixels de la pluralité de pixels, un temps d'émission (EMT) pendant lequel les pixels émettent une lumière, et un temps d'effacement (ERT) pendant lequel les pixels sont éteints.

13. Procédé selon la revendication 9, dans lequel une première différence entre la vitesse d'effacement et la vitesse d'écriture dans une première portion de l'au moins une sous-trame de compensation (SF4) est différente d'une seconde différence entre la vitesse d'effacement et la vitesse d'écriture dans une seconde portion de l'au moins une sous-trame de compensation (SF4).
